# EUROPEAN PATENT APPLICATION

(11) **EP 4 700 832 A1**
(43) Date of publication of application: **25.02.2026**
(21) Application number: 24815689.5
(22) Date of filing: 08.04.2024
(51) Int. Cl.: H01L 27/15, H01L 25/075, H01L 33/50, H01L 33/48, G09G 3/32

(54) **DISPLAY STRUCTURED TO PROVIDE DIFFERENT STATES FOR DISPLAYING SCREEN, AND ELECTRONIC DEVICE COMPRISING SAME**

(30) Priority: 31.05.2023 KR 20230070008; 28.06.2023 KR 20230083644
(71) Applicant: Samsung Electronics Co., Ltd., Suwon-si, Gyeonggi-do 16677 (KR)
(72) Inventor: SHIN, Sungyoung, Suwon-si Gyeonggi-do 16677 (KR); YANG, Byungduk, Suwon-si Gyeonggi-do 16677 (KR); PARK, Keehyon, Suwon-si Gyeonggi-do 16677 (KR); UHM, Minsuk, Suwon-si Gyeonggi-do 16677 (KR); LEE, Haechang, Suwon-si Gyeonggi-do 16677 (KR); KIM, Kwangtai, Suwon-si Gyeonggi-do 16677 (KR); YEOM, Donghyun, Suwon-si Gyeonggi-do 16677 (KR)
(74) Representative: Gulde & Partner
(86) International application number: PCT/KR2024/004672
(87) International publication number: WO 2024/248310

(57) **Abstract**

A display is provided. The display according to one embodiment comprises: a substrate; a plurality of spaced-apart LEDs, each including a first surface facing the substrate, a second surface opposite to the first surface from which light is emitted, and a side surface connecting the first surface and the second surface; a plurality of partition walls, which comprise a plurality of spaced-apart first partition walls having a first volume and a plurality of spaced-apart second partition walls, each having a second volume different from the first volume, and which surround the side surface of each of the plurality of LEDs; a plurality of first sub-pixels, each having a first viewing angle and being defined by the plurality of first partition walls; and a plurality of second sub-pixels, each having a second viewing angle, which is narrower than the first viewing angle, and being defined by the plurality of second partition walls.

## Description

### [Technical Field]

The present disclosure relates to a display including a structure to provide a different state for displaying a screen and an electronic device including the same.

### [Background Art]

An electronic device may provide visual information to a user through a display. The display of the electronic device may be configured to change a display state of the display based on identifying a request of the user or an event. For example, the electronic device may change the display state of the display to provide a screen based on identifying the request of the user or the event.

The above-described information may be provided as a related art for the purpose of helping understanding of the present disclosure. No argument or decision is made as to whether any of the above description may be applied as a prior art related to the present disclosure.

### [Disclosure]

### [Technical Solution]

A display is provided. According to an embodiment, the display may comprise a substrate. According to an embodiment, the display may comprise a plurality of LEDs spaced apart from each other and each of the plurality of LEDs including a first surface facing the substrate, a second surface through which light is emitted and opposite to the first surface, and a side surface connecting the first surface and the second surface. According to an embodiment, the display may comprise a plurality of barriers covering the side surface of each of the plurality of LEDs and including a plurality of first barriers having a first volume and spaced apart from each other, and a plurality of second barriers having a second volume different from the first volume and spaced apart from each other. According to an embodiment, the display may comprise a plurality of first sub-pixels defined by the plurality of first barriers and each of the plurality of first sub-pixels having a first viewing angle a1. According to an embodiment, the display may comprise a plurality of second sub-pixels defined by the plurality of second barriers and each of the plurality of second sub-pixels having a second viewing angle a2 narrower than the first viewing angle a1.

An electronic device is provided. According to an embodiment, the electronic device may comprise a display. According to an embodiment, the electronic device may comprise a display driving circuit configured to control the display. According to an embodiment, the display may include a substrate. According to an embodiment, the display may include a plurality of LEDs spaced apart from each other and each of the plurality of LEDs including a first surface facing the substrate, a second surface through which light is emitted and opposite to the first surface, and a side surface connecting the first surface and the second surface. According to an embodiment, the display may include a plurality of barriers covering the side surface of each of the plurality of LEDs and including a plurality of first barriers having a first volume and spaced apart from each other, and a plurality of second barriers having a second volume different from the first volume and spaced apart from each other. According to an embodiment, the display may include a plurality of first sub-pixels defined by the plurality of first barriers and each of the plurality of first sub-pixels having a first viewing angle a1. According to an embodiment, the display may include a plurality of second sub-pixels defined by the plurality of second barriers and each of the plurality of second sub-pixels having a second viewing angle a2 narrower than the first viewing angle a1. According to an embodiment, the display driving circuit may be configured to, in a first state, display, a screen on the display, based on activating the plurality of first sub-pixels and the plurality of second sub-pixels. According to an embodiment, the display driving circuit may be configured to, in a second state, display the screen on the display, based on activating a portion of the plurality of first sub-pixels and the plurality of second sub-pixels, or based on activating the plurality of second sub-pixels.

### [Description of the Drawings]

FIG. 1 is a block diagram of an electronic device in a network environment according to various embodiments.
FIG. 2 is a block diagram of a display module according to various embodiments.
FIG. 3 illustrates an exemplary electronic device according to an embodiment.
FIG. 4 is a cross-sectional view illustrating an example of an exemplary display cut along line A-A' of FIG. 3 according to an embodiment.
FIG. 5 is a cross-sectional view illustrating an example of cutting an exemplary display according to an embodiment.
FIG. 6 is a cross-sectional view illustrating an example of cutting an exemplary display according to an embodiment.
FIG. 7 is a cross-sectional view illustrating an example of cutting an exemplary display according to an embodiment.
FIG. 8 is a cross-sectional view illustrating an example of cutting an exemplary display according to an embodiment.
FIG. 9 is a cross-sectional view illustrating an example of cutting an exemplary display according to an embodiment.
FIG. 10A is a top view of sub-pixels of an exemplary display according to an embodiment.
FIG. 10B is a cross-sectional view illustrating an example of an exemplary display cut along line B-B' of FIG. 10A according to an embodiment.
FIG. 11 is a cross-sectional view illustrating an example of cutting an exemplary display according to an embodiment.
FIG. 12 is a cross-sectional view illustrating an example of cutting an exemplary display according to an embodiment.
FIG. 13 is a cross-sectional view illustrating an example of cutting an exemplary display according to an embodiment.
FIG. 14 is a cross-sectional view illustrating an exemplary display according to an embodiment.
FIG. 15 is a cross-sectional view illustrating an example of cutting an exemplary display according to an embodiment.
FIG. 16A is a top view of sub-pixels of an exemplary display according to an embodiment.
FIG. 16B is a cross-sectional view illustrating an example of an exemplary display cut along line C-C' of FIG. 16A according to an embodiment.
FIG. 17 is a cross-sectional view illustrating an example of cutting an exemplary display according to an embodiment.
FIG. 18 is a cross-sectional view illustrating an example of cutting an exemplary display according to an embodiment.
FIG. 19A is a top view of sub-pixels of an exemplary display according to an embodiment.
FIG. 19B is a top view of sub-pixels of an exemplary display according to an embodiment.
FIG. 19C is a cross-sectional view illustrating an example of an exemplary display cut along line D-D' of FIG. 19A according to an embodiment.
FIG. 19D is a cross-sectional view illustrating an example of an exemplary display cut along line E-E' of FIG. 19B according to an embodiment.
FIG. 20 indicates an exemplary electronic device according to an embodiment.
FIG. 21A is a cross-sectional view illustrating an example of cutting an exemplary display according to an embodiment.
FIG. 21B is a cross-sectional view illustrating an example of cutting an exemplary display according to an embodiment.

### [Mode for Invention]

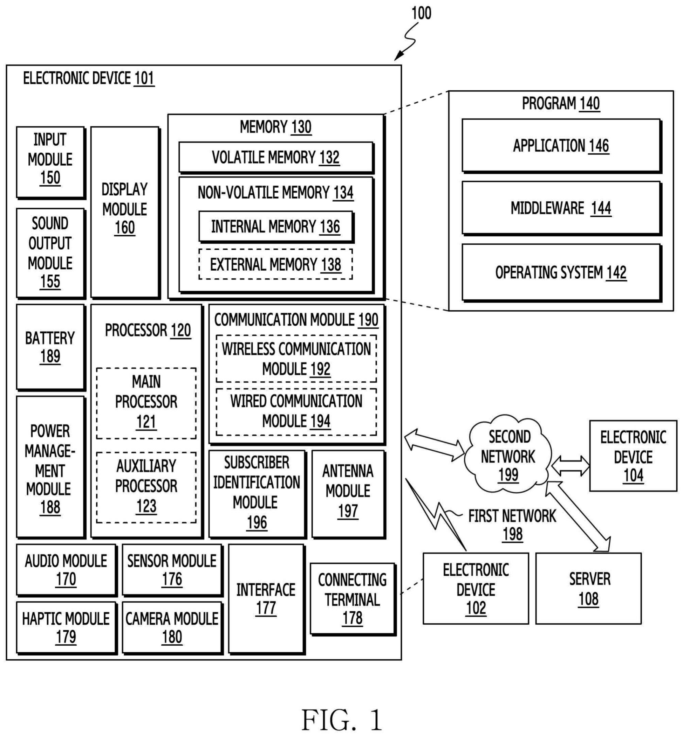

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or loT-related technology.

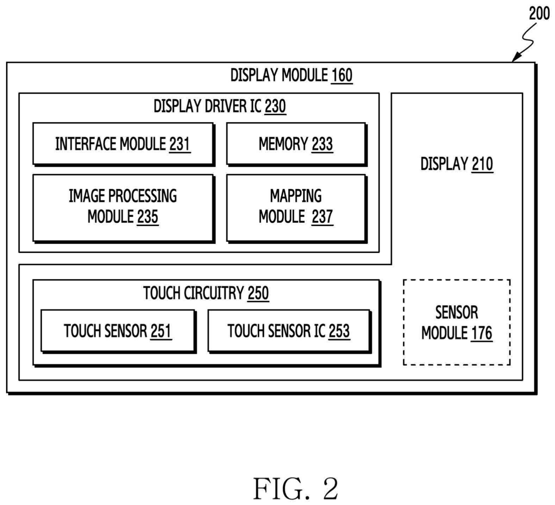

FIG. 2 is a block diagram 200 illustrating the display module 160 according to various embodiments.

Referring to FIG. 2, the display module 160 may include a display 210 and a display driver integrated circuit (DDI) 230 to control the display 210. The DDI 230 may include an interface module 231, memory 233 (e.g., buffer memory), an image processing module 235, or a mapping module 237. The DDI 230 may receive image information that contains image data or an image control signal corresponding to a command to control the image data from another component of the electronic device 101 via the interface module 231. For example, according to an embodiment, the image information may be received from the processor 120 (e.g., the main processor 121 (e.g., an application processor)) or the auxiliary processor 123 (e.g., a graphics processing unit) operated independently from the function of the main processor 121. The DDI 230 may communicate, for example, with touch circuitry 250 or the sensor module 176 via the interface module 231. The DDI 230 may also store at least part of the received image information in the memory 233, for example, on a frame by frame basis. The image processing module 235 may perform pre-processing or post-processing (e.g., adjustment of resolution, brightness, or size) with respect to at least part of the image data. According to an embodiment, the pre-processing or post-processing may be performed, for example, based at least in part on one or more characteristics of the image data or one or more characteristics of the display 210. The mapping module 237 may generate a voltage value or a current value corresponding to the image data preprocessed or post-processed by the image processing module 235. According to an embodiment, the generating of the voltage value or current value may be performed, for example, based at least in part on one or more attributes of the pixels (e.g., an array, such as an RGB stripe or a pentile structure, of the pixels, or the size of each subpixel). At least some pixels of the display 210 may be driven, for example, based at least in part on the voltage value or the current value such that visual information (e.g., a text, an image, or an icon) corresponding to the image data may be displayed via the display 210.

According to an embodiment, the display module 160 may further include the touch circuitry 250. The touch circuitry 250 may include a touch sensor 251 and a touch sensor IC 253 to control the touch sensor 251. The touch sensor IC 253 may control the touch sensor 251 to sense a touch input or a hovering input with respect to a certain position on the display 210. To achieve this, for example, the touch sensor 251 may detect (e.g., measure) a change in a signal (e.g., a voltage, a quantity of light, a resistance, or a quantity of one or more electric charges) corresponding to the certain position on the display 210. The touch circuitry 250 may provide input information (e.g., a position, an area, a pressure, or a time) indicative of the touch input or the hovering input detected via the touch sensor 251 to the processor 120. According to an embodiment, at least part (e.g., the touch sensor IC 253) of the touch circuitry 250 may be formed as part of the display 210 or the DDI 230, or as part of another component (e.g., the auxiliary processor 123) disposed outside the display module 160.

According to an embodiment, the display module 160 may further include at least one sensor (e.g., a fingerprint sensor, an iris sensor, a pressure sensor, or an illuminance sensor) of the sensor module 176 or a control circuit for the at least one sensor. In such a case, the at least one sensor or the control circuit for the at least one sensor may be embedded in one portion of a component (e.g., the display 210, the DDI 230, or the touch circuitry 250)) of the display module 160. For example, when the sensor module 176 embedded in the display module 160 includes a biometric sensor (e.g., a fingerprint sensor), the biometric sensor may obtain biometric information (e.g., a fingerprint image) corresponding to a touch input received via a portion of the display 210. As another example, when the sensor module 176 embedded in the display module 160 includes a pressure sensor, the pressure sensor may obtain pressure information corresponding to a touch input received via a partial or whole area of the display 210. According to an embodiment, the touch sensor 251 or the sensor module 176 may be disposed between pixels in a pixel layer of the display 210, or over or under the pixel layer.

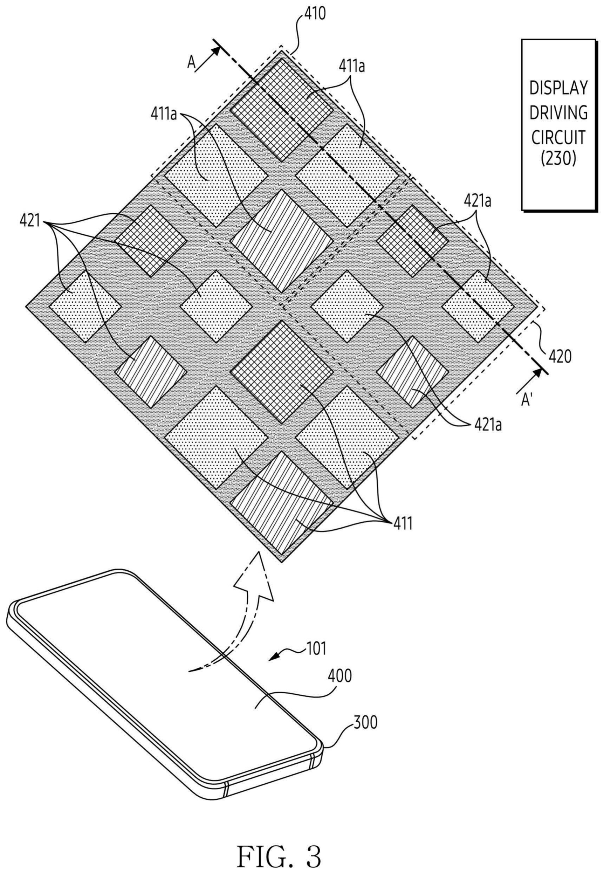

FIG. 3 illustrates an exemplary electronic device according to an embodiment.

Referring to FIG. 3, an electronic device 101 according to an embodiment may include a display driving circuit 230, a housing 300, and/or a display 400 (e.g., the display 210 of FIG. 2).

According to an embodiment, the housing 300 may define (or form) at least a portion of an outer surface of the electronic device 101. The housing 300 may accommodate various components of the electronic device 101. For example, the housing 300 may include an internal space in which various components of the electronic device 101 may be accommodated. The housing 300 may support various components of the electronic device 101. For example, the housing 300 may support the display 400. For example, the display 400 may be disposed on the housing 300.

According to an embodiment, the display 400 may be configured to provide visual information. The display 400 may be configured to emit light for providing visual content (or content). The display 400 may include a plurality of first pixels 410 and a plurality of second pixels 420. The display 400 may be configured to emit light through the plurality of first pixels 410 and/or the plurality of second pixels 420. Each of the plurality of first pixels 410 may include a plurality of first sub-pixels 411. For example, the plurality of first sub-pixels 411 may define (or form) each of the plurality of first pixels 410. For example, the plurality of first sub-pixels 411 may include sub-pixels of a first set 411a that define or form one first pixel of the plurality of first pixels 410. For example, the first set 411a of sub-pixels may include one sub-pixel for emitting red light, two sub-pixels for emitting green light, and/or one sub-pixel for emitting blue light, but it is not limited thereto. For example, the first set 411a of sub-pixels may include one sub-pixel for emitting red light, one sub-pixel for emitting green light, and/or one sub-pixel for emitting blue light. Each of the plurality of second pixels 420 may include a plurality of second sub-pixels 421. For example, the plurality of second sub-pixels 421 may define (or form) each of the plurality of second pixels 420. For example, the plurality of second sub-pixels 421 may include sub-pixels of a second set 421a that define one second pixel among the plurality of second pixels 420. For example, the second set 421a of sub-pixels may include one sub-pixel for emitting red light, two sub-pixels for emitting green light, and/or one sub-pixel for emitting blue light, but it is not limited thereto. For example, the second set 421a of sub-pixels may include one sub-pixel for emitting red light, one sub-pixel for emitting green light, and/or one sub-pixel for emitting blue light. A viewing angle of the plurality of second pixels 420 may be narrower than a viewing angle of the plurality of first pixels 410. For example, each of the plurality of second sub-pixels 421 may have a narrower viewing angle than each of the plurality of first sub-pixels 411.

According to an embodiment, the display driving circuit 230 may control the display 400. The display driving circuit 230 may control driving of each of the plurality of first pixels 410 and/or the plurality of second pixels 420 in the display 400. For example, the display driving circuit 230 may control driving of the display 400 by activating or deactivating at least a portion of the plurality of first sub-pixels 411, and/or at least a portion of the plurality of second sub-pixels 421. According to an embodiment, a state of the display driving circuit 230 may include a first state and/or a second state. The display driving circuit 230 may be configured to display a screen on the display 400 based on activating the plurality of first pixels 410 and the plurality of second pixels 420, in the first state. For example, the display driving circuit 230 may display the screen on the display 400 based on activating the plurality of first sub-pixels 411 and the plurality of second sub-pixels 421, in the first state. The first state may be referred to, for example, as a first mode. The display driving circuit 230 may display a screen on the display 400 based on activating the plurality of second pixels 420 and deactivating at least a portion of the plurality of first pixels 410, in the second state. For example, the display driving circuit 230 may display the screen on the display 400 based on activating the plurality of second sub-pixels 421 and deactivating at least a portion of the plurality of first sub-pixels 411, in the second state. For example, the display driving circuit 230 may display the screen on the display 400 based on deactivating all of the plurality of first sub-pixels 411 and activating the plurality of second sub-pixels 421, in the second state. For example, the display driving circuit 230 may display the screen on the display 400 based on deactivating a portion of the plurality of first sub-pixels 411 and activating the plurality of second sub-pixels 421, in the second state. The second state may be referred to, for example, as a second mode or a private mode. Since at least a portion of the plurality of first subpixels 411 having a wider viewing angle than the plurality of second subpixels 421 are deactivated in the second state, a viewing angle of the screen displayed on the display 400 in the second state may be narrower than a viewing angle of the screen displayed on the display 400 in the first state. Since the viewing angle of the screen displayed on the display 400 in the second state is relatively narrow, the electronic device 101 may provide visual information to a user of the electronic device 101 without exposing the screen of the display 400 to anyone other than the user of the electronic device 101. As the screen of the display 400 is not exposed to anyone other than the user, privacy of the user of the electronic device 101 may be protected.

According to an embodiment, each of the plurality of first sub-pixels 411 may have a first viewing angle. Each of the plurality of second sub-pixels 421 may have a second viewing angle narrower than the first viewing angle. For example, a structure in which each of the plurality of second sub-pixels 421 has a different viewing angle from each of the plurality of first sub-pixels 411 may be described with reference to the following drawings.

Meanwhile, in FIG. 3, the display 400 is illustrated to be disposed on the electronic device 101 having a bar shape, but it is not limited thereto. For example, the electronic device 101 may be disposed on at least one of a foldable device and/or a rollable device, in which a shape of the display 400 is changed. The foldable device may include a shape of a multi-foldable device in which the display 400 may be folded a plurality of times.

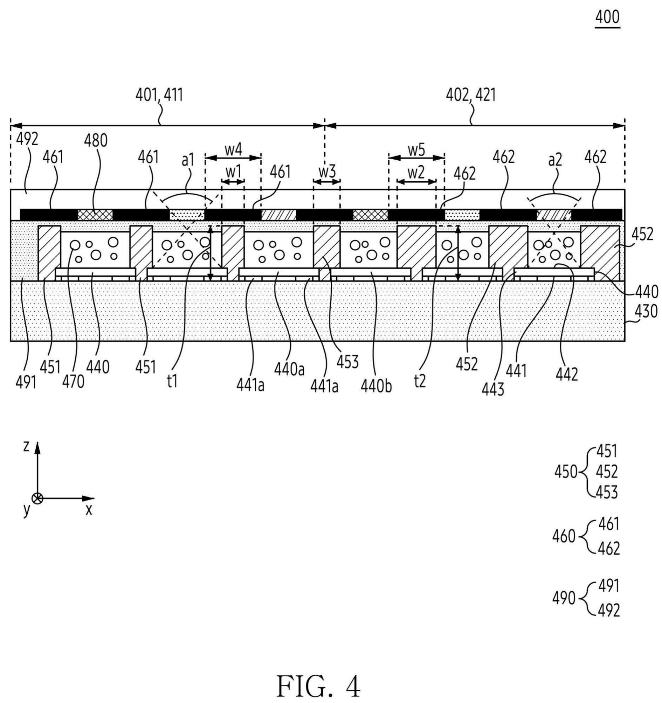

FIG. 4 is a cross-sectional view illustrating an example of an exemplary display cut along line A-A' of FIG. 3 according to an embodiment.

Referring to FIG. 4, according to an embodiment, a display 400 may include a substrate 430, a plurality of LEDs 440, a plurality of barriers 450, a plurality of blocking members 460, a plurality of light conversion members 470, a plurality of color filters 480, and/or at least one passivation layer 490.

According to an embodiment, the substrate 430 may support the plurality of LEDs 440. The substrate 430 may be electrically connected to the plurality of LEDs 440. For example, the substrate 430 may be formed of at least one of glass and/or silicon, but it is not limited thereto. Although not illustrated in FIG. 4, the display 400 may include a plurality of TFTs (not illustrated) disposed on the substrate 430. The plurality of TFTs may drive the plurality of LEDs 440. The plurality of TFTs may be disposed between the substrate 430 and the plurality of LEDs 440, but it is not limited thereto. For example, the plurality of TFTs may be formed based on low temperature polycrystalline silicon (LTPS) or low temperature polycrystalline oxide (LTPO).

According to an embodiment, the plurality of LEDs 440 may be configured to emit light. For example, the plurality of LEDs 440 may be formed (or manufactured) of an inorganic material. For example, the plurality of LEDs 440 may not include an organic material to reduce a burn-in phenomenon caused by long-term use of the display 400. For example, the plurality of LEDs 440 may be referred to as a plurality of light emitting elements. According to an embodiment, each of the plurality of LEDs 440 may include a first surface 441, a second surface 442, and/or at least one side surface 443. The first surface 441 may face the substrate 430. Electrodes 441a of each of the plurality of LEDs 440 may be disposed on the first surface 441. The electrodes 441a of each of the plurality of LEDs 440 may be formed on the first surface 441. The electrodes 441a of each of the plurality of LEDs 440 may include a positive electrode and a negative electrode. The electrodes 441a of each of the plurality of LEDs 440 may be attached to the first surface 441 and the substrate 430. The second surface 442 may be opposite to the first surface 441. For example, a direction (e.g., +z direction) in which the second surface 442 faces may be opposite to a direction (e.g., -z direction) in which the first surface 441 faces. For example, the second surface 442 may be substantially parallel to the first surface 441. Each of the plurality of LEDs 440 may be configured to emit light through the second surface 442. The at least one side surface 443 may connect the first surface 441 and the second surface 442. The at least one side surface 443 may be disposed (or positioned) between the first surface 441 and the second surface 442. The at least one side surface 443 may extend from the first surface 441 to the second surface 442. For example, the at least one side surface 443 may be substantially perpendicular to the first surface 441 and/or the second surface 442, but it is not limited thereto. For example, a direction (e.g., +x direction, +y direction, and/or -y direction) in which the at least one side 443 faces may be perpendicular to the direction (e.g., -z direction) in which the first surface 441 faces.

According to an embodiment, each of the plurality of LEDs 440 may be referred to as a micro LED. In a case that each of the plurality of LEDs 440 is referred to as the micro LED, each of a width and a length of each of the plurality of LEDs 440 may be approximately 100 µm or less. A width of one component may indicate a distance in the +x direction and/or a -x direction, and a corresponding expression may be also used substantially the same below unless otherwise stated. A length of one element may indicate a distance in the +y direction and/or the -y direction, and a corresponding expression may be also used substantially the same below unless otherwise stated. According to an embodiment, each of the plurality of LEDs 440 may emit light having substantially the same color. For example, each of the plurality of LEDs 440 may emit blue light, but it is not limited thereto. For example, the plurality of LEDs 440 may include LEDs that emit blue light, LEDs that emit green light, and LEDs that emit red light. According to an embodiment, each of the plurality of LEDs 440 may be spaced apart from each other. Each of the plurality of LEDs 440 may be disposed in each of a plurality of first sub-pixels 411 and a plurality of second sub-pixels 421. For example, the number of the plurality of LEDs 440 may be substantially the same as a sum of the number of the plurality of first sub-pixels 411 and the number of the plurality of second sub-pixels 421.

According to an embodiment, the plurality of barriers 450 may cover (or surround) the plurality of LEDs 440. For example, the plurality of barriers 450 may cover (or surround) the at least one side surface 443 of each of the plurality of LEDs 440. For example, a plurality of barriers 450 may be in contact with the at least one side surface 443 of each of the plurality of LEDs 440. For example, at least a portion of the plurality of barriers 450 may be disposed between the plurality of LEDs 440. According to an embodiment, the plurality of barriers 450 may cover a portion of the second surface 442 of each of the plurality of LEDs 440. For example, the plurality of barriers 450 may be in contact with the portion of the second surface 442 of each of the plurality of LEDs 440. According to an embodiment, the plurality of barriers 450 may extend from the substrate 430. For example, the plurality of barriers 450 may extend along the direction (e.g., +z direction) in which the second surface 442 faces from the substrate 430. However, it is not limited thereto. For example, the plurality of barriers 450 may be spaced apart from the substrate 430. On the other hand, only a shape in which the plurality of barriers 450 extend along the direction (e.g., +z direction) in which the second surface 442 faces is illustrated in FIG. 4, but it is not limited thereto. For example, the plurality of barriers 450 may cover (or surround) the at least one side surface 443 of each of the plurality of LEDs 440 by extending along a direction (e.g., +x direction or -x direction) parallel to the second surface 442.

According to an embodiment, the plurality of barriers 450 may limit a viewing angle of each of the plurality of LEDs 440. The plurality of barriers 450 may accommodate (or surround) the plurality of light conversion members 470. For example, the plurality of barriers 450 may be referred to as a plurality of banks. The plurality of barriers 450 may define (or form) each of the first sub-pixels 411 and the second sub-pixels 421. For example, the plurality of barriers 450 may define each of the first sub-pixels 411 and the second sub-pixels 421 together with the plurality of LEDs 440 and the plurality of blocking members 460. For example, the plurality of barriers 450 may include a plurality of first barriers 451 and/or a plurality of second barriers 452. The plurality of first barriers 451 may define (or form) the plurality of first sub-pixels 411. The plurality of first barriers 451 may surround (or surround) a portion of the plurality of LEDs 440 disposed in the plurality of first sub-pixels 411. Each of the plurality of first barriers 451 may have a first volume. Areas of the plurality of LEDs 440 in the plurality of first sub-pixels 411 covered by each of the plurality of first barriers 451 may be the same. The plurality of second barriers 452 may define (or form) the plurality of second sub-pixels 421. The plurality of second barriers 452 may surround (or surround) another portion of the plurality of LEDs 440 disposed in the plurality of second sub-pixels 421. Areas of the plurality of LEDs 440 in the plurality of second sub-pixels 421 covered by each of the plurality of second barriers 452 may be the same. Each of the plurality of second barriers 452 may have a second volume larger than the first volume. A volume of one component may be defined through a width, a length, and/or a thickness of one component, but it is not limited thereto. A thickness of one component may indicate a distance in a direction (e.g., +z direction and/or -z direction) parallel to the direction (e.g., +z direction) in which the second surface 442 faces, and a corresponding expression may be also used substantially the same unless otherwise stated below.

According to an embodiment, the display 400 may include a first area 401 and a second area 402. The plurality of first sub-pixels 411 may be disposed in the first area 401 of the display 400. The first area 401 may indicate a portion of the display 400 including the plurality of first sub-pixels 411. The plurality of second sub-pixels 421 may be disposed in the second area 402 of the display 400. The second area 402 may indicate a portion of the display 400 including the plurality of second sub-pixels 421. A volume of the plurality of second barriers 452 disposed in the second area 402 of the display 400 may be greater than a volume of the plurality of first barriers 451 disposed in the first area 401 of the display 400. For example, the second volume of each of the plurality of second barriers 452 may be greater than the first volume of each of the plurality of first barriers 451. For example, a volume of all of the plurality of second barriers 452 disposed in the second area 402 may be greater than a volume of all of the plurality of first barriers 451 disposed in the first area 401. For example, a second width w2 of each of the plurality of second barriers 452 may be longer than a first width w1 of each of the plurality of first barriers 451. When the second width w2 is longer than the first width w1, a second thickness t2 of each of the plurality of second barriers 452 may be greater than or equal to a first thickness t1 of each of the plurality of first barriers 451, but it is not limited thereto. Since the second width w2 of each of the plurality of second barriers 452 is longer than the first width w1 of each of the plurality of first barriers 451, an area in which the second surface 442 of each of the plurality of LEDs 440 in the plurality of second sub-pixels 421 is covered by the plurality of second barriers 452 may be greater than an area covered by the plurality of first barriers 451. Since the second width w2 is longer than the first width w1, a second viewing angle a2 of the plurality of second sub-pixels 421 may be narrower than a first viewing angle a1 of the plurality of first sub-pixels 411. According to an embodiment, when the display 400 is viewed along the direction (e.g., -z direction) in which the first surface 441 faces, a size of each of the plurality of second sub-pixels 421 may be smaller than a size of each of the plurality of first sub-pixels 411.

According to an embodiment, the plurality of barriers 450 may include at least one third barrier 453. The at least one third barrier 453 may be disposed between the plurality of first sub-pixels 411 and the plurality of second sub-pixels 421. For example, the at least one third barrier 453 may be disposed between the plurality of first barriers 451 and the plurality of second barriers 452. The at least one third barrier 453 may have a third volume between the first volume and the second volume. For example, the third volume may be greater than the first volume and smaller than the second volume. For example, the third volume may be substantially the same as a sum of half of the first volume and half of the second volume. According to an embodiment, the third width w3 of the at least one third barrier 453 may be greater than the first width w1 of each of the plurality of first barriers 451 and smaller than the second width w2 of each of the plurality of second barriers 452. For example, the third width w3 of the at least one third barrier 453 may be substantially the same as the sum of the half of the first width w1 of each of the plurality of first barriers 451 and the half of the second width w2 of each of the plurality of second barriers 452. For example, in a case that the third volume of the at least one third barrier 453 is substantially the same as the first volume, since an area of one LED 440a in the plurality of first sub-pixels 411 covered by at least one third barrier 453 and an area of one LED 440 in the plurality of first sub-pixels 411 covered by the plurality of first barriers 451 are different from each other, the plurality of first sub-pixels 411 may not have a uniform viewing angle. For example, in a case that the third volume of the at least one third barrier 453 is substantially the same as the first volume, since an area of one LED 440b in the at least one second sub-pixel 421 covered by the at least one third barrier 453 and an area of one LED 440 in the plurality of second sub-pixels 421 covered by the plurality of second barriers 452 are different from each other, the plurality of second sub-pixels 421 may not have a uniform viewing angle. An electronic device (e.g., the electronic device 101 of FIG. 3) according to an embodiment may provide a structure in which each of the plurality of first sub-pixels 411 and the plurality of second sub-pixels 421 has a substantially uniform viewing angle, by the at least one third barrier 453 disposed between the plurality of first sub-pixels 411 and the plurality of second sub-pixels 421.

According to an embodiment, the plurality of blocking members 460 may limit a viewing angle of the plurality of LEDs 440 together with the plurality of barriers 450. For example, the plurality of blocking members 460 may include materials for absorbing light from the plurality of LEDs 440. For example, the plurality of blocking members 460 may be formed (or defined) of a material (e.g., a black series material) for absorbing the light from the plurality of LEDs 440. For example, each of the plurality of blocking members 460 may be referred to as a black matrix (BM). According to an embodiment, each of the plurality of blocking members 460 may be disposed on each of the plurality of barriers 450. For example, the plurality of blocking members 460 may include a plurality of first blocking members 461 and a plurality of second blocking members 462. The plurality of first blocking members 461 may define (or form) the plurality of first sub-pixels 411 together with the plurality of first barriers 451. The plurality of first blocking members 461 may be disposed on each of the plurality of first barriers 451. For example, the plurality of first blocking members 461 may be spaced apart from the plurality of first barriers 451 along the direction (e.g., +z direction) in which the second surface 442 faces, but it is not limited thereto. For example, a fourth width w4 of each of the plurality of first blocking members 461 may be greater than or equal to the first width w1 of each of the plurality of first barriers 451. Since the fourth width w4 of each of the plurality of first blocking members 461 is greater than the first width w1 of each of the plurality of first barriers 451, the plurality of first barriers 451 may not be visually recognized outside the electronic device 101. The plurality of second blocking members 462 may define (or form) the plurality of second sub-pixels 421 together with the plurality of second barriers 452. The plurality of second blocking members 462 may be disposed on each of the plurality of second barriers 452. For example, the plurality of second blocking members 462 may be spaced apart from the plurality of second barriers 452 along the direction (e.g., +z direction) in which the second surface 442 faces, but it is not limited thereto. For example, a fifth width w5 of each of the plurality of second blocking members 462 may be greater than or equal to the second width w2 of each of the plurality of second barriers 452. Since the fifth width w5 of each of the plurality of second blocking members 462 is greater than the second width w2 of each of the plurality of second barriers 452, the plurality of second barriers 452 may not be visually recognized outside the electronic device 101. According to an embodiment, the fifth width w5 of each of the plurality of second blocking members 462 may be substantially the same as the fourth width w4 of each of the plurality of first blocking members 461, but it is not limited thereto.

According to an embodiment, each of the plurality of light conversion members 470 may be configured to convert a color (or a wavelength) of light emitted from each of the plurality of LEDs 440. For example, the plurality of light conversion members 470 may include a quantum dot (QD) material. For example, the plurality of light conversion members 470 may be formed of the quantum dot (QD) material. For example, in a case that each of the plurality of LEDs 440 emits blue light, the plurality of light conversion members 470 may include materials for converting the blue light into green light or red light. For example, in a case that each of the plurality of LEDs 440 emits the blue light, the plurality of light conversion members 470 may be disposed in sub-pixels for emitting the green light or sub-pixels for emitting the red light, and may not be disposed on sub-pixels for emitting the blue light. However, it is not limited thereto. For example, in a case that each of the plurality of LEDs 440 emits the blue light, the plurality of light conversion members 470 may be disposed in the sub-pixels for emitting the green light, the sub-pixels for emitting the red light, and the sub-pixels for emitting the blue light. For example, in a case that the plurality of LEDs 440 include LEDs that emit the blue light, LEDs that emit the green light, and LEDs that emit the red light, the plurality of light conversion members 470 may be omitted. According to an embodiment, the plurality of light conversion members 470 may be accommodated in the plurality of barriers 450. For example, the plurality of light conversion members 470 may be covered (or surrounded) by the plurality of barriers 450. Each of the plurality of light conversion members 470 may be disposed on the second surface 442 of each of the plurality of LEDs 440. For example, each of the plurality of light conversion members 470 may be in contact with the second surface 442 of each of the plurality of LEDs 440.

According to an embodiment, the plurality of color filters 480 may be configured to convert the color (or the wavelength) of the light emitted from each of the plurality of LEDs 440. For example, the plurality of color filters 480 may increase purity of a color of the light that has passed through the plurality of light conversion members 470. According to an embodiment, the plurality of color filters 480 may be disposed on the plurality of light conversion members 470. The plurality of color filters 480 may be disposed between the plurality of blocking members 460. The plurality of color filters 480 may form (or define) one layer with the plurality of blocking members 460. For example, a distance from the substrate 430 to the plurality of blocking members 460 may be substantially the same as a distance from the substrate 430 to the plurality of color filters 480.

According to an embodiment, at least one passivation layer 490 may compensate (or remove) for a step caused by components in the display 400. For example, at least one passivation layer 490 may include a first passivation layer 491 and/or a second passivation layer 492. The first passivation layer 491 may be disposed on the substrate 430. The first passivation layer 491 may cover (or surround) the plurality of barriers 450. For example, the first passivation layer 491 may be in contact with the plurality of blocking members 460 and the plurality of light conversion members 470, but it is not limited thereto. The second passivation layer 492 may be disposed on the plurality of blocking members 460 and the plurality of color filters 480. The second passivation layer 492 may cover (or surround) the plurality of blocking members 460 and the plurality of color filters 480.

As described above, since the second viewing angle a2 of the plurality of second sub-pixels 421 defined by the plurality of second barriers 452 having a volume different from the plurality of first barriers 451 is different from the first viewing angle a1 of the plurality of first sub-pixels 411, the electronic device 101 according to an embodiment may provide a structure capable of protecting privacy of a user.

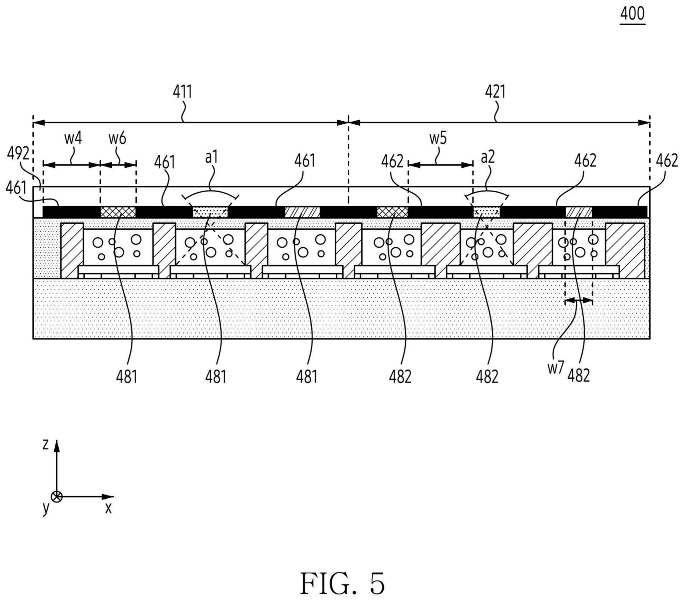

FIG. 5 is a cross-sectional view illustrating an example of cutting an exemplary display according to an embodiment.

Since a display 400 of FIG. 5 may be a display 400 in which a structure of each of a plurality of blocking members 460 and a plurality of color filters 480 is changed in the display 400 of FIG. 4, a redundant description will be omitted.

Referring to FIG. 5, according to an embodiment, the plurality of color filters 480 may include a plurality of first color filters 481 and a plurality of second color filters 482. The plurality of first color filters 481 may be disposed in a plurality of first sub-pixels 411. The plurality of first color filters 481 may be disposed between a plurality of first blocking members 461. The plurality of second color filters 482 may be disposed in a plurality of second sub-pixels 421. The plurality of second color filters 482 may be disposed between a plurality of second blocking members 462.

According to an embodiment, a fifth width w5 of each of the plurality of second blocking members 462 may be greater than a fourth width w4 of each of the plurality of first blocking members 461. Since the fifth width w5 is greater than the fourth width w4, a second viewing angle a2 of the plurality of second sub-pixels 421 may be smaller than a first viewing angle a1 of the plurality of first sub-pixels 411. For example, since the fifth width w5 is greater than the fourth width w4, a size of each of the plurality of second sub-pixels 421 may be smaller than a size of each of the plurality of first sub-pixels 411 when a display 400 is viewed along a direction (e.g., - z direction) in which a first surface 441 faces .

According to an embodiment, a sixth width w6 of each of the plurality of first color filters 481 may be greater than a seventh width w7 of each of the plurality of second color filters 482. For example, since the fifth width w5 of each of the plurality of second blocking members 462 is greater than the fourth width w4 of each of the plurality of first blocking members 461, the seventh width w7 of the plurality of second color filters 482 between the plurality of second blocking members 462 may be smaller than the sixth width w6 of the plurality of first color filters 481.

As described above, since the fifth width w5 of the plurality of second blocking members 462 is greater than the fourth width w4 of the plurality of first blocking members 461, an electronic device (e.g., the electronic device 101 of FIG. 3) according to an embodiment may provide a structure in which the second viewing angle a2 of the plurality of second sub-pixels 421 is narrower than the first viewing angle a1.

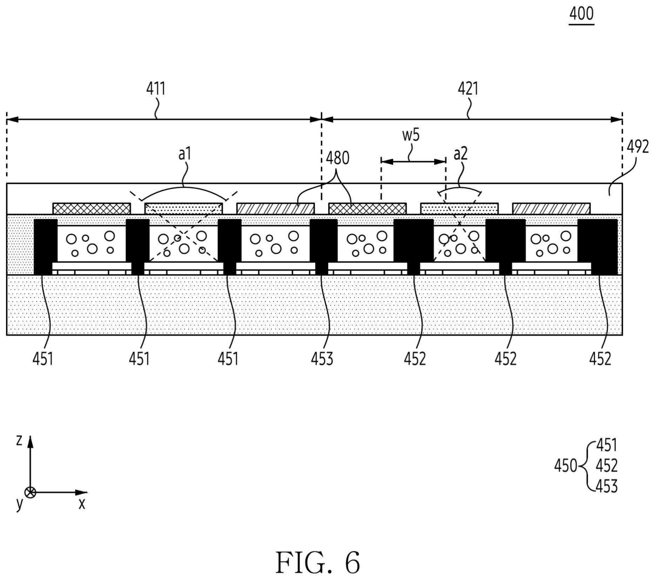

FIG. 6 is a cross-sectional view illustrating an example of cutting an exemplary display according to an embodiment.

Since a display 400 of FIG. 6 may be a display 400 in which a structure of a plurality of barriers 450 is changed in the display 400 of FIG. 4, a redundant description will be omitted.

Referring to FIG. 6, according to an embodiment, the plurality of barriers 450 may include a material for blocking light. For example, the plurality of barriers 450 may be formed of substantially the same material as a material for forming a plurality of blocking members (e.g., the plurality of blocking members 460 of FIG. 4). For example, a plurality of first barriers 451 may be formed of a material that absorbs light (e.g., a black series material). For example, a plurality of second barriers 452 may be formed of the material that absorbs the light (e.g., the black series material). For example, at least one third barrier 453 may be formed of the material that absorbs the light (e.g., the black series material).

According to an embodiment, a second passivation layer 492 may be interposed (or disposed) between a plurality of color filters 480. For example, the plurality of blocking members 460 of FIG. 4 may be omitted from the display 400 of FIG. 6. As the plurality of blocking members 460 are omitted, a process for manufacturing the display 400 may be simplified. A second viewing angle a2 of a plurality of second sub-pixels 421 may be defined by the plurality of second barriers 452. A first viewing angle a1 of a plurality of first sub-pixels 411 may be defined by the plurality of first barriers 451.

As described above, an electronic device (e.g., the electronic device 101 of FIG. 3) according to an embodiment may provide a structure in which the second viewing angle a2 of the plurality of second sub-pixels 421 is narrower than the first viewing angle a1 since the plurality of barriers 450 include the material that absorbs the light.

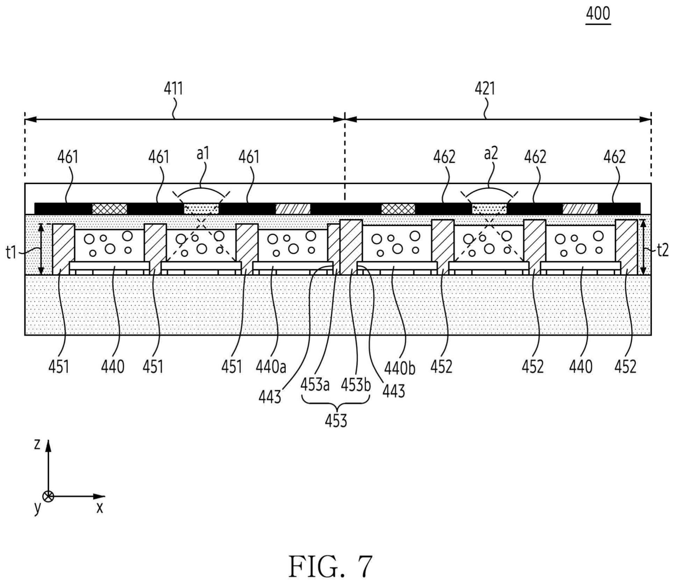

FIG. 7 is a cross-sectional view illustrating an example of cutting an exemplary display according to an embodiment.

Since a display 400 of FIG. 7 may be a display 400 in which a structure of a plurality of barriers 450 is changed in the display 400 of FIG. 4, a redundant description will be omitted.

Referring to FIG. 7, according to an embodiment, a first thickness t1 of each of a plurality of first barriers 451 may be different from a second thickness t2 of each of a plurality of second barriers 452. The second thickness t2 of each of the plurality of second barriers 452 may be greater than the first thickness t1 of each of the plurality of first barriers 451. A width of each of the plurality of barriers 450 may be substantially the same, but it is not limited thereto. Since the first thickness t1 is greater than the second thickness t2, a second volume of each of the plurality of second barriers 452 may be greater than a first volume of each of the plurality of first barriers 451. Since the first thickness t1 is greater than the second thickness t2, a second viewing angle a2 of each of a plurality of second sub-pixels 421 defined by the plurality of second barriers 452 may be smaller than a first viewing angle a1 of each of a plurality of first sub-pixels 411 defined by the plurality of first barriers 451.

According to an embodiment, at least one third barrier 453 may include a first portion 453a and a second portion 453b having different thicknesses. The first portion 453a may have the first thickness t1. The first portion 453a may surround at least one side surface 443 of one LED 440a in the plurality of first sub-pixels 411. The second portion 453b may have the second thickness t2. The second portion 453b may surround the at least one side surface 443 of one LED 440b in the plurality of second sub-pixels 421. For example, in a case that the thicknesses of each of the first portion 453a and the second portion 453b are the same, the plurality of first sub-pixels 411 may not have a uniform viewing angle, or the plurality of second sub-pixels 421 may not have a uniform viewing angle. An electronic device (e.g., the electronic device 101 of FIG. 3) according to an embodiment may provide a structure in which each of the plurality of first sub-pixels 411 and the plurality of second sub-pixels 421 has a substantially uniform viewing angle by the at least one third barrier 453 including the first portion 453a and the second portion 453b having different thicknesses.

According to an embodiment, a distance between the plurality of second barriers 452 and a plurality of second blocking members 462 may be shorter than a distance between the plurality of first barriers 451 and a plurality of first blocking members 461. However, it is not limited thereto.

As described above, the electronic device 101 according to an embodiment may provide a structure in which the first viewing angle a1 of each of the plurality of first sub-pixels 411 and the second viewing angle a2 of each of the plurality of second sub-pixels 421 are different by the plurality of first barriers 451 and the plurality of second barriers 452 having different thicknesses.

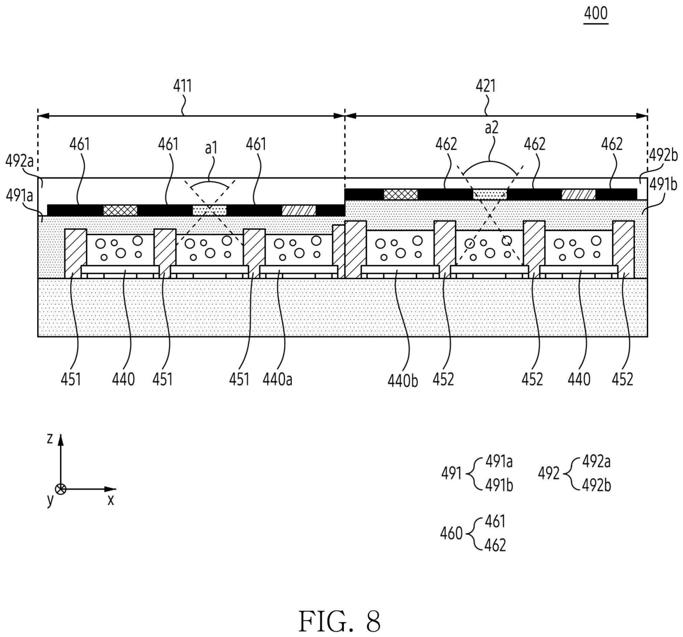

FIG. 8 is a cross-sectional view illustrating an example of cutting an exemplary display according to an embodiment.

Since a display 400 of FIG. 8 may be a display 400 in which a structure of a plurality of blocking members 460 is changed in the display 400 of FIG. 7, a redundant description will be omitted.

Referring to FIG. 8, according to an embodiment, a distance between a plurality of second barriers 452 and a plurality of second blocking members 462 may be substantially the same as a distance between a plurality of first barriers 451 and a plurality of first blocking members 461. A distance between a portion of a plurality of LEDs 440 and the plurality of first blocking members 461 in a plurality of first sub-pixels 411 may be smaller than a distance between another portion of the plurality of LEDs 440 and the plurality of second blocking members 462 in a plurality of second sub-pixels 421. For example, a distance between one LED 440b and the plurality of second blocking members 462 in the plurality of second sub-pixels 421 may be greater than a distance between one LED 440a and the plurality of first blocking members 461 in the plurality of first sub-pixels 411. Since the distance between the portion of the plurality of LEDs 440 and the plurality of second blocking members 462 in the plurality of second sub-pixels 421 is greater than the distance between the portion of the plurality of LEDs 440 and the plurality of first blocking members 461 in the plurality of first sub-pixels 411, a second viewing angle a2 of the plurality of second sub-pixels 421 may be smaller than a first viewing angle a1 of the plurality of first sub-pixels 411.

According to an embodiment, a first passivation layer 491 may include a step formed between the plurality of first sub-pixels 411 and the plurality of second sub-pixels 421. A portion 491a of the first passivation layer 491 may cover (or surround) the plurality of first barriers 451. The portion 491a of the first passivation layer 491 may be in contact with the plurality of first blocking members 461 and the plurality of first barriers 451. Another portion 491b of the first passivation layer 491 may define (or form) a step with respect to the portion 491a of the first passivation layer 491. The other portion 491b of the first passivation layer 491 may cover (or surround) the plurality of second barriers 452. The other portion 491b of the first passivation layer 491 may be in contact with the plurality of second blocking members 462 and the plurality of second barriers 452.

According to an embodiment, a second passivation layer 492 may include a step formed between the plurality of first sub-pixels 411 and the plurality of second sub-pixels 421. A portion 492a of the second passivation layer 492 may be disposed on the plurality of first blocking members 461. Another portion 492b of the second passivation layer 492 may be disposed on the plurality of second blocking members 462. The other portion 492b of the second passivation layer 492 may define (or form) a step with respect to the portion 492a of the second passivation layer 492.

As described above, an electronic device (e.g., the electronic device 101 of FIG. 3) according to an embodiment may provide a structure in which the second viewing angle a2 of the plurality of second sub-pixels 421 are narrower than the first viewing angle a1 of the plurality of first sub-pixels 411 since the distance between the plurality of LEDs 440 and the plurality of second blocking members 462 in the plurality of second sub-pixels 421 is greater than the distance between the plurality of LEDs 440 and the plurality of first blocking members 461 in the plurality of first sub-pixels 411.

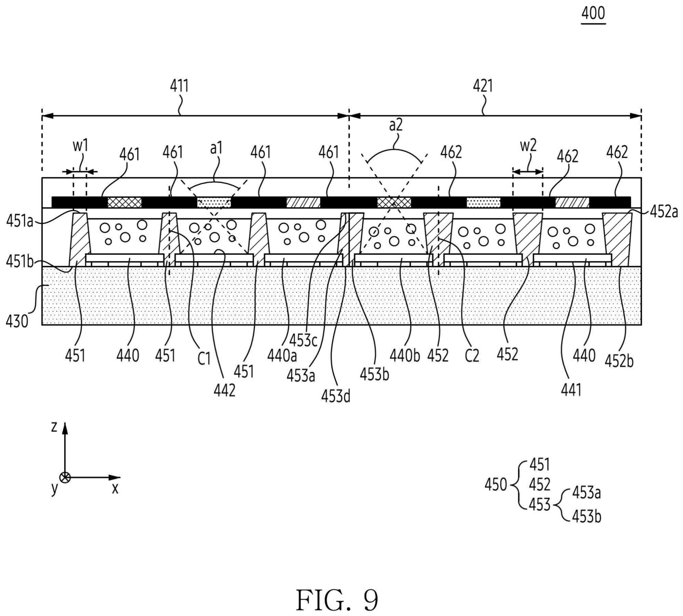

FIG. 9 is a cross-sectional view illustrating an example of cutting an exemplary display according to an embodiment.

Since a display 400 of FIG. 9 may be a display 400 in which a structure of a plurality of barriers 450 is changed in the display 400 of FIG. 4, a redundant description will be omitted.

Referring to FIG. 9, according to an embodiment, a shape of each of a plurality of second barriers 452 may be different from a shape of each of a plurality of first barriers 451. For example, a size of a surface 452a of each of the plurality of second barriers 452 may be different from a size of a surface 451a of each of the plurality of first barriers 451. The surface 452a of each of the plurality of second barriers 452 may face a direction (e.g., +z direction) in which a second surface 442 faces. For example, the surface 452a of each of the plurality of second barriers 452 may face a plurality of second blocking members 462. The surface 451a of each of the plurality of first barriers 451 may face the direction (e.g., +z direction) in which the second surface 442 faces. For example, the surface 451a of each of the plurality of first barriers 451 may face a plurality of first blocking members 461. For example, an area of the surface 452a of each of the plurality of second the 452 may be greater than an area of the surface 451a of each of the plurality of first barriers 451. Since the area of the surface 452a of each of the plurality of second barriers 452 is greater than the area of the surface 451a of each of the plurality of first barriers 451, a second viewing angle a2 of each of a plurality of second sub-pixels 421 may be smaller than a first viewing angle a1 of each of a plurality of first sub-pixels 411.

According to an embodiment, a first width w1 of each of the plurality of first barriers 451 may be changed as it extends from a substrate 430. For example, the first width w1 of each of the plurality of first barriers 451 may decrease as it goes farther from the substrate 430. For example, an area of another surface 451b of each of the plurality of first barriers 451, which is opposite to the surface 451a, may be greater than the area of the surface 451a. For example, the other surface 451b of each of the plurality of first barriers 451 may face a direction (e.g., -z direction) in which a first surface 441 faces. For example, the other surface 451b of each of the plurality of first barriers 451 may face the substrate 430.

According to an embodiment, a second width w2 of each of the plurality of second barriers 452 may be changed as it extends from the substrate 430. For example, the second width w2 of each of the plurality of second barriers 452 may increase as it goes farther from the substrate 430. For example, an area of another surface 452b of each of the plurality of second barriers 452, which is opposite to the surface 452a, may be smaller than the area of the surface 452a. For example, the other surface 452b of each of the plurality of second barriers 452 may face the direction (e.g., -z direction) in which the first surface 441 faces. For example, the other surface 452b of each of the plurality of second barriers 452 may face the substrate 430. For example, an area of the other surface 452b of each of the plurality of second barriers 452 may be substantially the same as the area of the other surface 451b of each of the plurality of first barriers 451, but it is not limited thereto.

According to an embodiment, a shape of at least one third barrier 453 may be different from shapes of the plurality of first barriers 451 and the plurality of second barriers 452. For example, the at least one barrier 453 may include a first portion 453a and a second portion 453b. The first portion 453a may have substantially the same shape as a shape of half of each of the plurality of first barriers 451. For example, each of the plurality of first barriers 451 may have a symmetrical shape with respect to a center line c1. The first portion 453a may have substantially the same shape as the shape of the half of each of the plurality of first barriers 451 divided with respect to the center line c1. The second portion 453b may have substantially the same shape as a shape of half of each of the plurality of second barriers 452. For example, each of the plurality of second barriers 452 may have a symmetrical shape with respect to a center line c2. The second portion 453b may have substantially the same shape as the shape of the half of each of the plurality of second barriers 452 divided with respect to the center line c2. For example, in a case that the shape of the at least one third barrier 453 is the same as the shape of each of the plurality of first barriers 451 or the shape of each of the plurality of second barriers 452, the plurality of first sub-pixels 411 may not have a uniform viewing angle, or the plurality of second sub-pixels 421 may not have a uniform viewing angle. An electronic device (e.g., the electronic device 101 of FIG. 3) according to an embodiment may provide a structure in which each of the plurality of first sub-pixels 411 and the plurality of second sub-pixels 421 has a substantially uniform viewing angle, by the at least one third barrier 453 having a shape different from the shape of each of the plurality of first barriers 451 and the shape of each of the plurality of second barriers 452.

According to an embodiment, an area of a surface 453c of the at least one third barrier 453 may be different from an area of another surface 453d of the at least one third barrier 453. The surface 453c of the at least one third barrier 453 may face the direction (e.g., +z direction) in which the second surface 442 faces. The other surface 453d of the at least one third barrier 453 may be opposite to the surface 453c of the at least one third barrier 453. The other surface 453d of the at least one third barrier 453 may face the direction (e.g., -z direction) in which the first surface 441 faces. For example, the area of the surface 453c of the at least one third barrier 453 may be substantially the same as a sum of half of the area of the surface 451a of each of the plurality of first barriers 451 and half of the area of the surface 452a of each of the plurality of second barriers 452. The area of the other surface 453d of the at least one third barrier 453 may be substantially the same as a sum of half of the area of the other surface 451b of each of the plurality of first barriers 451 and half of the area of the other surface 452b of each of the plurality of second barriers 452.

As described above, the electronic device 101 according to an embodiment may provide a structure in which the second viewing angle a2 of the plurality of second sub-pixels 421 is different from the first viewing angle a1 of the plurality of first sub-pixels 411, by the plurality of second barriers 452 having a different shape from the plurality of first barriers 451.

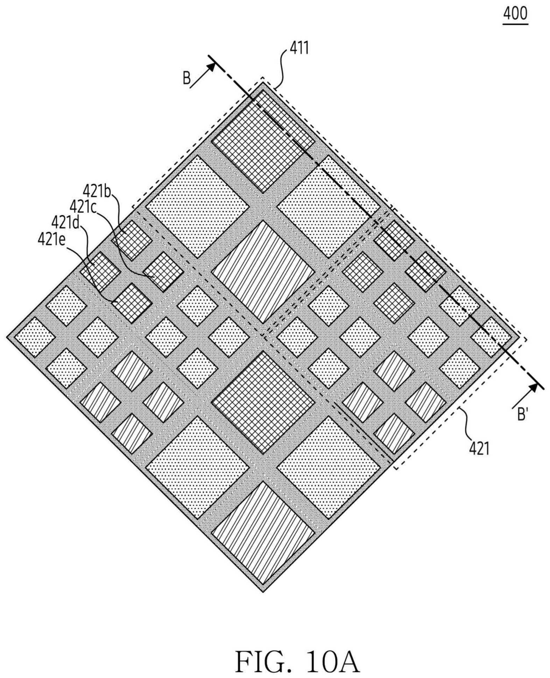

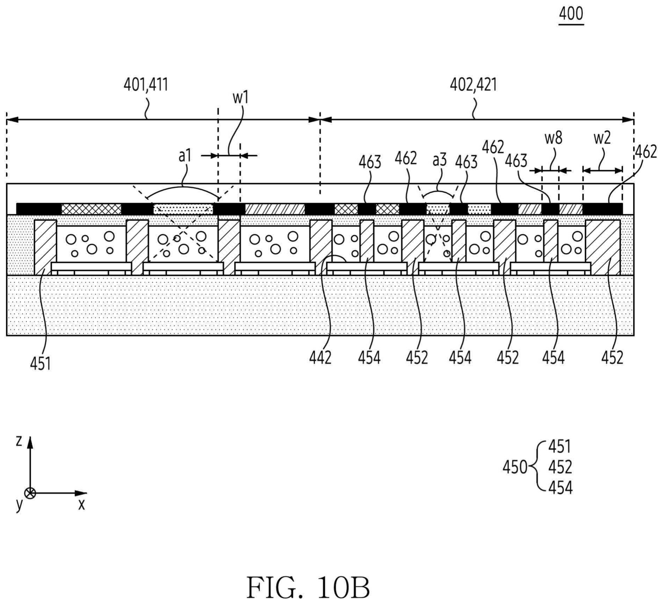

FIG. 10A is a top view of sub-pixels of an exemplary display according to an embodiment, and FIG. 10B is a cross-sectional view illustrating an example of an exemplary display cut along line B-B' of FIG. 10A according to an embodiment.

Since a display 400 of FIGS. 10A and 10B may be a display 400 in which a structure of a plurality of barriers 450 is changed in the display 400 of FIG. 4, a redundant description will be omitted.

Referring to FIGS. 10A and 10B, according to an embodiment, a sum of volumes of a portion of the plurality of barriers 450 disposed in a first area 401 may be different from a sum of volumes of another portion of the plurality of barriers 450 disposed in a second area 402. For example, the sum of the volumes of the portion of the plurality of barriers 450 disposed in the first area 401 may be smaller than the sum of the volumes of the other portion of the plurality of barriers 450 disposed in the second area 402.

According to an embodiment, the plurality of barriers 450 may include a plurality of fourth barriers 454. The plurality of fourth barriers 454 may be disposed between a plurality of second barriers 452. The plurality of fourth barriers 454 may be disposed in a plurality of second sub-pixels 421. For example, the plurality of fourth barriers 454 may divide each of the plurality of second sub-pixels 421. For example, each of the plurality of second sub-pixels 421 may be divided into a plurality of micro-pixels 421b, 421c, 421d, and 421e smaller than a size of each of the plurality of second sub-pixels 421 by the plurality of fourth barriers 454. A third viewing angle a3 of each of the plurality of micropixels 421b, 421c, 421d, and 421e defined (or formed) by the plurality of fourth barriers 454 may be smaller than a first viewing angle a1 of each of a plurality of first sub-pixels 411. According to an embodiment, the plurality of fourth barriers 454 may extend from a second surface 442. For example, the plurality of fourth barriers 454 may extend from the second surface 442 along a direction (e.g., +z direction) in which the second surface 442 faces.

According to an embodiment, an eighth width w8 of each of the plurality of fourth barriers 454 may be smaller than a second width w2 of each of the plurality of second barriers 452, but it is not limited thereto. For example, the eighth width w8 of each of the plurality of fourth barriers 454 may be substantially the same as the second width w2 of each of the plurality of second barriers 452. For example, the eighth width w8 of each of the plurality of fourth barriers 454 may be greater than the second width w2 of each of the plurality of second barriers 452.

According to an embodiment, a first width w1 of the plurality of first barriers 451 may be substantially the same as the second width w2 of the plurality of second barriers 452. However, it is not limited thereto. For example, the second width w2 may be greater than the first width w1.

According to an embodiment, a plurality of blocking members 460 may include a plurality of third blocking members 463. The plurality of third blocking members 463 may divide each of the plurality of second sub-pixels 421 into the plurality of micro-pixels 421b, 421c, 421d, and 421e, together with the plurality of fourth barriers 454. The plurality of third blocking members 463 may be disposed between a plurality of second blocking members 462.

As described above, an electronic device (e.g., the electronic device 101 of FIG. 3) according to an embodiment may provide a structure including the plurality of micropixels 421b, 421c, 421d, and 421e having the third viewing angle a3 different from the first viewing angle a1 of each of the plurality of first subpixels 411, by the plurality of fourth barriers 454 dividing the plurality of second sub-pixels 421.

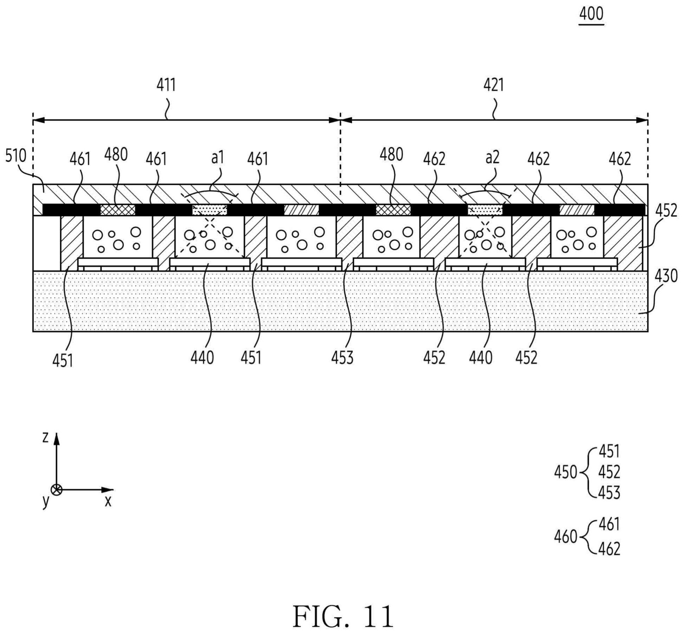

FIG. 11 is a cross-sectional view illustrating an example of cutting an exemplary display according to an embodiment.

A display 400 of FIG. 11 is a display 400 to which at least one passivation layer 490 (e.g., a second passivation layer 492) is omitted from the display 400 of FIG. 4, and a covering layer 510 is added.

Referring to FIG. 11, according to an embodiment, the display 400 may further include the covering layer 510. The covering layer 510 may be formed of a material (e.g., glass) capable of transmitting light. For example, the covering layer 510 may be exposed to the outside of an electronic device (e.g., the electronic device 101 of FIG. 3). The covering layer 510 may be disposed on a plurality of blocking members 460 and a plurality of color filters 480. For example, the plurality of blocking members 460 and the plurality of color filters 480 may be formed on the covering layer 510. For example, when the display 400 is manufactured, a plurality of barriers 450 may be formed after a plurality of LEDs 440 are disposed on a substrate 430. After a plurality of first barriers 451, a plurality of second barriers 452, and at least one third barrier 453 are formed, a plurality of light conversion members 470 may be accommodated between the plurality of barriers 450. The plurality of blocking members 460 and the plurality of color filters 480 may be formed on the covering layer 510. After the plurality of blocking members 460 and the plurality of color filters 480 are formed on the covering layer 510, the covering layer 510 to which the plurality of blocking members 460 and the plurality of color filters 480 are attached may be disposed on the plurality of barriers 450, thereby completing the manufacture of the display 400.

According to an embodiment, the plurality of blocking members 460 may be in contact with the plurality of barriers 450. For example, a plurality of first blocking members 461 may be in contact with the plurality of first barriers 451. For example, a plurality of second blocking members 462 may be in contact with the plurality of second barriers 452.

According to an embodiment, the plurality of first blocking members 461 and the plurality of second blocking members 462 may be in contact with the covering layer 510. The plurality of first blocking members 461 and the plurality of second blocking members 462 may be attached to the covering layer 510. The plurality of first blocking members 461 and the plurality of second blocking members 462 may be formed on the covering layer 510.

The electronic device 101 according to an embodiment may provide a structure capable of protecting privacy of a use since a second viewing angle a2 of a plurality of second sub-pixels 421 defined by the plurality of second barriers 452 having a different volume from the plurality of first barriers 451, is different from a first viewing angle a1 of a plurality of first sub-pixels 411.

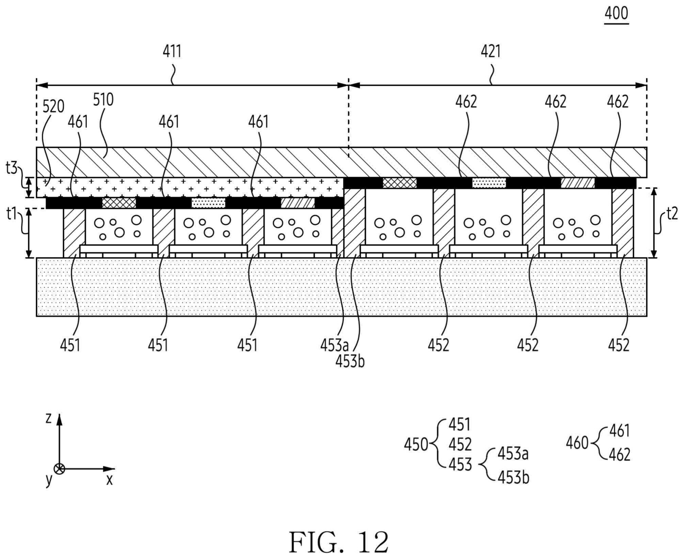

FIG. 12 is a cross-sectional view illustrating an example of cutting an exemplary display according to an embodiment.

Since a display 400 of FIG. 12 is a display 400 to which at least one passivation layer 490 (e.g., a second passivation layer 492) is omitted from the display 400 of FIG. 8, and a covering layer 510 and a compensation layer 520 are added, a redundant description will be omitted.

Referring to FIG. 12, according to an embodiment, a plurality of first blocking members 461 may be disposed on a plurality of first barriers 451 having a first thickness t1. A plurality of second blocking members 462 may be disposed on a plurality of second barriers 452 having a second thickness t2. A step may be formed (or defined) between the plurality of first blocking members 461 and the plurality of second blocking members 462. For example, a distance between one LED 440a and the plurality of first blocking members 461 in a plurality of first sub-pixels 411 may be smaller than a distance between one LED 440b and the plurality of second blocking members 462 in a plurality of second sub-pixels 421.

According to an embodiment, the display 400 may further include the compensation layer 520. The compensation layer 520 may compensate for a step due to a difference in thickness between the plurality of first barriers 451 and the plurality of second barriers 452. For example, a third thickness t3 of the compensation layer 520 may be substantially the same as a difference between the second thickness t2 and the first thickness t1. As the compensation layer 520 compensates for the step between the plurality of first barriers 451 and the plurality of second barriers 452, an area to which the covering layer 510 may be attached may be secured.

According to an embodiment, the compensation layer 520 may be disposed on the plurality of first barriers 451. For example, the compensation layer 520 may be disposed (or interposed) between the plurality of first blocking members 461 and the covering layer 510. For example, the compensation layer 520 may be disposed on a first portion 453a among the first portion 453a and a second portion 453b of at least one third barrier 453.

As described above, an electronic device (e.g., the electronic device 101 of FIG. 3) according to an embodiment may provide a structure capable of removing the step due to the difference in thickness between the plurality of first barriers 451 and the plurality of second barriers 452, by the compensation layer 520.

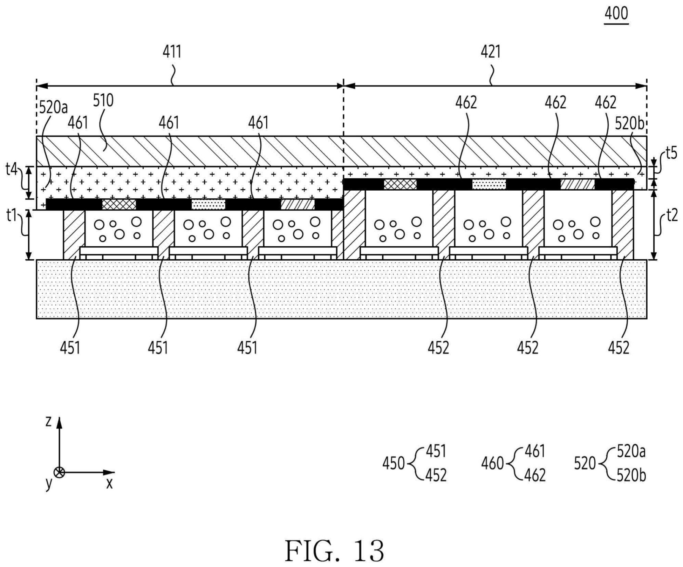

FIG. 13 is a cross-sectional view illustrating an example of cutting an exemplary display according to an embodiment.

Since a display 400 of FIG. 13 may be a display 400 in which a structure of a compensation layer 520 is changed in the display 400 of FIG. 12, a redundant description will be omitted.

Referring to FIG. 13, according to an embodiment, a portion 520a of the compensation layer 520 may be disposed on a plurality of first blocking members 461. A portion 520a of the compensation layer 520 may be disposed (or interposed) between the plurality of first blocking members 461 and a covering layer 510. For example, a fourth thickness t4 of the portion 520a of the compensation layer 520 may be different from a difference between a second thickness t2 and a first thickness t1. For example, the fourth thickness t4 may be greater than the difference between the second thickness t2 and the first thickness t1, but it is not limited thereto.

According to an embodiment, another portion 520b of the compensation layer 520 may be connected to the portion 520a of the compensation layer 520. The other portion 520b of the compensation layer 520 may be disposed on a plurality of second barriers 452. The other portion 520b of the compensation layer 520 may be disposed (or interposed) between a plurality of second blocking members 462 and the covering layer 510. The other part 520b of the compensation layer 520 may form a step with respect to the portion 520a of the compensation layer 520. For example, a fifth thickness t5 of the other portion 520b of the compensation layer 520 may be thinner than the fourth thickness t4 of the portion 520a of the compensation layer 520. For example, a difference between the fifth thickness t5 and the fourth thickness t4 may be substantially the same as the difference between the second thickness t2 and the first thickness t1. As the difference between the fifth thickness t5 and the fourth thickness t4 is substantially the same as the difference between the second thickness t2 and the first thickness t1, a step due to the first thickness t1 of a plurality of first barriers 451 and the second thickness t2 of the plurality of second barriers 452 may be compensated.

As described above, an electronic device (e.g., the electronic device 101 of FIG. 3) according to an embodiment may provide a structure capable of removing a step due to the difference in thickness between the plurality of first barriers 451 and the plurality of second barriers 452, by the portion 520a and the other portion 520b of the compensation layer 520.

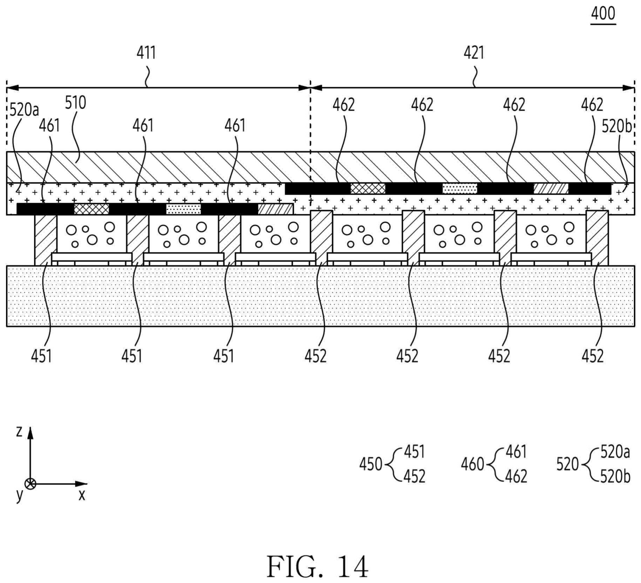

FIG. 14 is a cross-sectional view illustrating an exemplary display according to an embodiment.

Since a display 400 of FIG. 14 may be a display 400 in which a structure of a plurality of barriers 450 and a structure of a compensation layer 520 are changed in the display 400 of FIG. 13, a redundant description will be omitted.

Referring to FIG. 14, according to an embodiment, the plurality of barriers 450 may include a plurality of first barriers 451 and a plurality of second barriers 452. For example, the plurality of barriers 450 may not include at least one third barrier (e.g., the at least one third barrier 453 of FIG. 12).

According to an embodiment, a plurality of second blocking members 462 may be disposed on the plurality of second barriers 452. The plurality of second blocking members 462 may be spaced apart from the plurality of second barriers 452 along a direction (e.g., +z direction) in which a second surface 442 faces.

According to an embodiment, another portion 520b of the compensation layer 520 may be disposed under the plurality of second blocking members 462. For example, the other portion 520b of the compensation layer 520 may be disposed between the plurality of second barriers 452 and the plurality of second blocking members 462.

As described above, an electronic device (e.g., the electronic device 101 of FIG. 3) according to an embodiment may provide a structure capable of removing a step due to a difference in thickness between the plurality of first barriers 451 and the plurality of second barriers 452, by a portion 520a and the other portion 520b of the compensation layer 520.

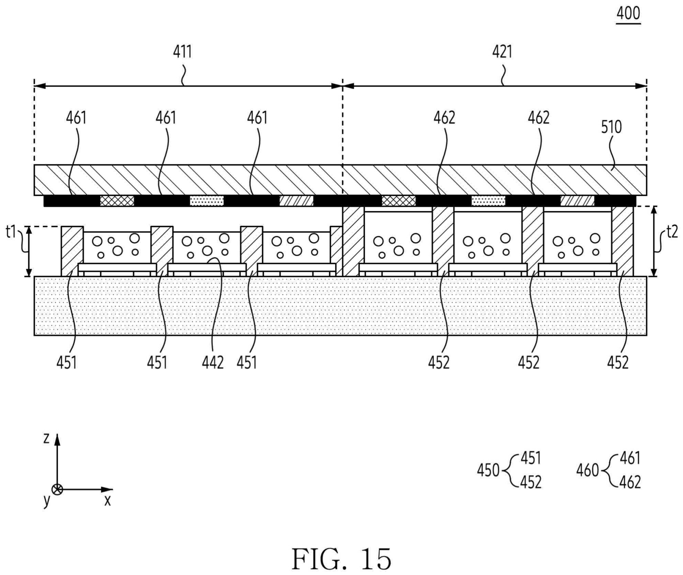

FIG. 15 is a cross-sectional view illustrating an example of cutting an exemplary display according to an embodiment.

Since a display 400 of FIG. 15 may be a display 400 in which a structure of a plurality of blocking members 460 is changed and a compensation layer 520 is removed in the display 400 of FIG. 12, a redundant description will be omitted.

Referring to FIG. 15, according to an embodiment, a plurality of first blocking members 461 may be spaced apart from a plurality of first barriers 451. For example, the plurality of first blocking members 461 may be spaced apart from a plurality of first barriers 451 along a direction (e.g., +z direction) in which a second surface 442 faces. For example, a distance between the plurality of first blocking members 461 and the plurality of first barriers 451 may be substantially the same as a difference between a first thickness t1 and a second thickness t2, but it is not limited thereto. Since the plurality of blocking members 460 are formed on a covering layer 510 when the display 400 is manufactured, the plurality of first blocking members 461 and the plurality of first barriers 451 may be spaced apart from each other.

Meanwhile, in FIG. 15, a plurality of second blocking members 462 are illustrated to be in contact with a plurality of second barriers 452, but embodiments are not limited thereto. For example, the plurality of second blocking members 462 may be spaced apart from the plurality of second barriers 452. For example, the plurality of second blocking members 462 may be spaced apart from the plurality of second barriers 452 along the direction (e.g., +z direction) in which the second surface 442 faces.

As described above, an electronic device (e.g., the electronic device 101 of FIG. 3) according to an embodiment may provide a structure in which the plurality of first blocking members 461 and the plurality of first barriers 451 are spaced apart from each other since the plurality of blocking members 460 are attached to the covering layer 510.

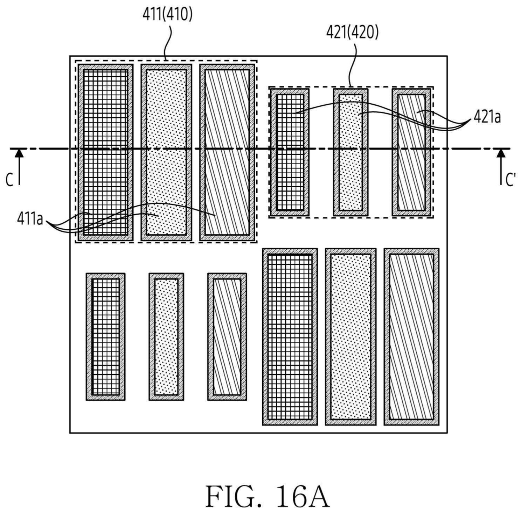

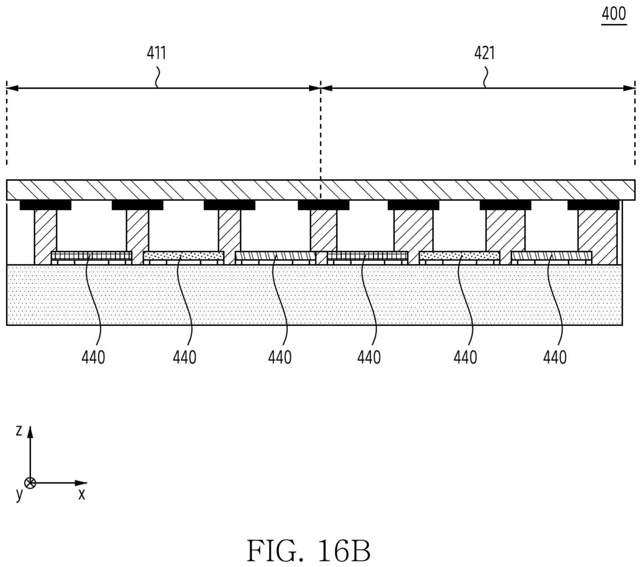

FIG. 16A is a top view of sub-pixels of an exemplary display according to an embodiment, and FIG. 16B is a cross-sectional view illustrating an example of an exemplary display cut along line C-C' of FIG. 16A according to an embodiment.

Since a display 400 of FIGS. 16A and 16B may be a display 400 in which light conversion members (e.g., the plurality of light conversion members 470 of FIG. 4) and a plurality of color filters (e.g., the plurality of color filters 480 of FIG. 4) are deleted from the display 400 of FIG. 11, a redundant description will be omitted.

Referring to FIGS. 16A and 16B, according to an embodiment, each of a plurality of first sub-pixels 411 in a plurality of first pixels 410 may emit light having different colors. For example, a first set 411a of sub-pixels may include one sub-pixel that emits blue light, one sub-pixel that emits green light, and one sub-pixel that emits red light. Each of a plurality of LEDs 440 disposed in each of the first set 411a of sub-pixels may emit light having different colors. For example, the first set 411a of sub-pixels may include one LED that emits blue light, one LED that emits green light, and one LED that emits red light.

According to an embodiment, as the colors of the light emitted from the plurality of LEDs 440 disposed in each of the first set 411a of sub-pixels are different, a plurality of light conversion members 470 may be omitted in each of the plurality of first sub-pixels 411. As the colors of the light emitted from the plurality of LEDs 440 disposed in each of the first set 411a of sub-pixels are different, the plurality of light conversion members 470 may not be disposed in each of the plurality of first sub-pixels 411. According to an embodiment, as the colors of the light emitted from the plurality of LEDs 440 disposed in each of the first set 411a of sub-pixels are different, the plurality of color filters 480 may be omitted in each of the plurality of first sub-pixels 411. As the colors of the light emitted from the plurality of LEDs 440 disposed in each of the first set 411a of sub-pixels are different, the plurality of color filters 480 may not be disposed in each of the plurality of first sub-pixels 411.

According to an embodiment, a plurality of second sub-pixels 421 in a plurality of second pixels 420 may emit light having different colors. For example, a second set 421a of sub-pixels may include one sub-pixel that emits blue light, one sub-pixel that emits green light, and one sub-pixel that emits red light. Each of the plurality of LEDs 440 disposed in each of the second set 421a of sub-pixels may emit light having different colors. For example, the second set 421a of sub-pixels may include one LED that emits blue light, one LED that emits green light, and one LED that emits red light.

According to an embodiment, as the colors of the light emitted from the plurality of LEDs 440 disposed in each of the second set 421a of sub-pixels are different, the plurality of light conversion members 470 may be omitted in each of the plurality of second sub-pixels 421. As the colors of the light emitted from the plurality of LEDs 440 disposed in each of the second set 421a of sub-pixels are different, the plurality of light conversion members 470 may not be disposed in each of the plurality of second sub-pixels 421. According to an embodiment, as the colors of the light emitted from the plurality of LEDs 440 disposed in each of the second set 421a of sub-pixels are different, the plurality of color filters 480 may be omitted in each of the plurality of second sub-pixels 421. As the colors of the light emitted from the plurality of LEDs 440 disposed in each of the second set 421a of sub-pixels are different, the plurality of color filters 480 may not be disposed in each of the plurality of second sub-pixels 422.

As described above, an electronic device (e.g., electronic device 101 of FIG. 3) according to an embodiment may provide a second state for protecting privacy of a user through the first set 411a of sub-pixels and the second set 421a of sub-pixels including sub-pixels emitting different light.

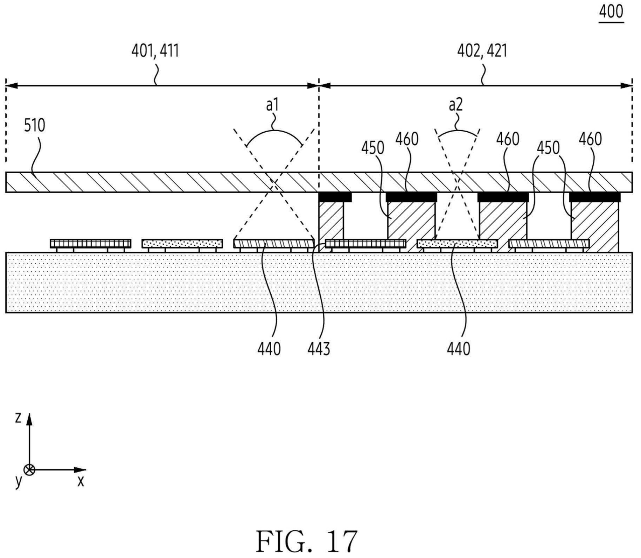

FIG. 17 is a cross-sectional view illustrating an example of cutting an exemplary display according to an embodiment.

Since a display 400 of FIG. 17 may be a display 400 in which a structure of a plurality of barriers 450 is changed in the display 400 of FIGS. 16A and 16B, a redundant description will be omitted.

Referring to FIG. 17, according to an embodiment, a plurality of first sub-pixels 411 in a first area 401 may be defined only by a plurality of LEDs 440. For example, the plurality of barriers 450 may not define the plurality of first sub-pixels 411. For example, the plurality of barriers 450 may not cover at least one side surface 443 of each of the plurality of LEDs 440 disposed in the plurality of first sub-pixels 411. For example, the plurality of barriers 450 may not be disposed in the first area 401.

According to an embodiment, the plurality of barriers 450 may define each of a plurality of second sub-pixels 421. The plurality of second sub-pixels 421 may be defined by the plurality of LEDs 440, the plurality of barriers 450, and a plurality of blocking members 460. For example, the plurality of barriers 450 may cover (or surround) the at least one side surface 443 of each of the plurality of LEDs 440 disposed in the plurality of second sub-pixels 421. For example, the plurality of barriers 450 may be disposed in a second area 402 among the first area 401 and the second area 402. For example, widths of each of the plurality of barriers 450 may be substantially the same, but it is not limited thereto.

According to an embodiment, the plurality of blocking members 460 may be disposed in the second area 402 among the first area 401 and the second area 402. For example, the plurality of blocking members 460 may be in contact with a portion of a covering layer 510 disposed in the second area 402. Since the plurality of barriers 450 and the plurality of blocking members 460 are disposed only in the second area 402 in which the plurality of second sub-pixels 421 are disposed, a second viewing angle a2 of the plurality of second sub-pixels 421 may be smaller than a first viewing angle a1 of the plurality of first sub-pixels 411.

As described above, an electronic device (e.g., the electronic device 101 of FIG. 3) according to an embodiment may provide a structure in which the second viewing angle a2 of the plurality of second sub-pixels 421 is narrower than the first viewing angle a1 of the plurality of first sub-pixels 411, by the plurality of barriers 450 disposed in the second area 402 of the display 400 on which the plurality of second sub-pixels 421 are disposed.

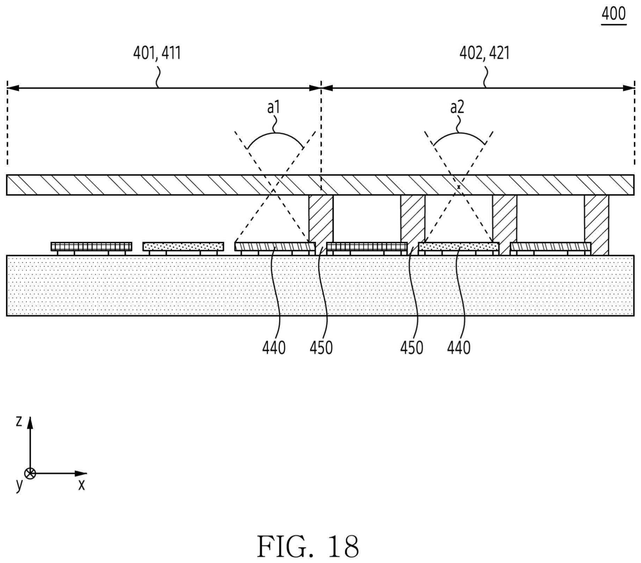

FIG. 18 is a cross-sectional view illustrating an example of cutting an exemplary display according to an embodiment.

Since a display 400 of FIG. 18 may be a display 400 to which a plurality of blocking members (e.g., the plurality of blocking members 460 of FIG. 17) are omitted from the display 400 of FIG. 17, a redundant description will be omitted.

Referring to FIG. 18, according to an embodiment, a plurality of barriers 450 may be in contact with a covering layer 510. For example, the plurality of barriers 450 may be formed of a material for forming the plurality of blocking members 460. For example, the plurality of barriers 450 may be formed of a material for absorbing light emitted from a plurality of LEDs 440, but it is not limited thereto.

As described above, an electronic device (e.g., the electronic device 101 of FIG. 3) according to an embodiment may provide a structure in which a second viewing angle a2 of a plurality of second sub-pixels 421 is narrower than a first viewing angle a1 of a plurality of first sub-pixels 411, by the plurality of barriers 450 disposed in a second area 402 of the display 400 on which the plurality of second sub-pixels 421 are disposed.

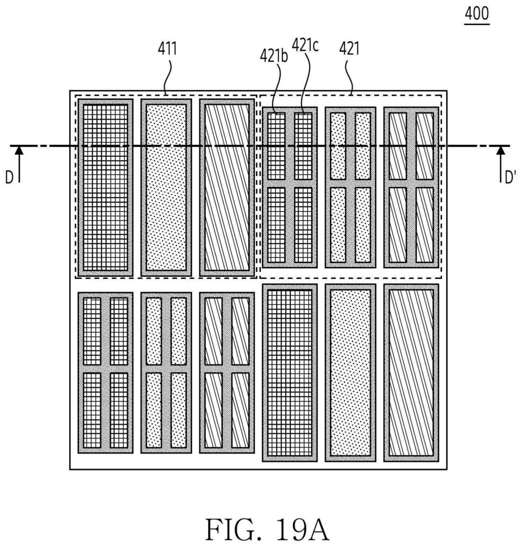

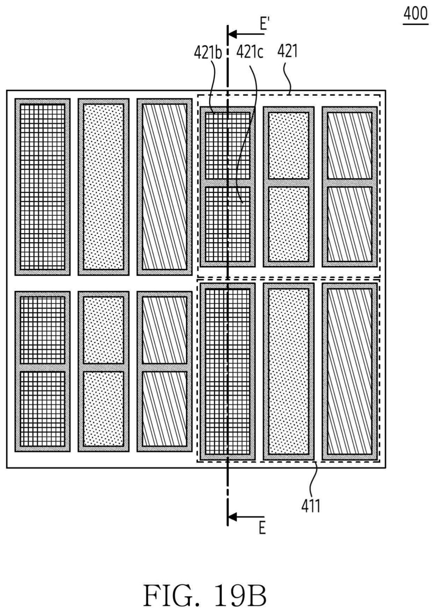

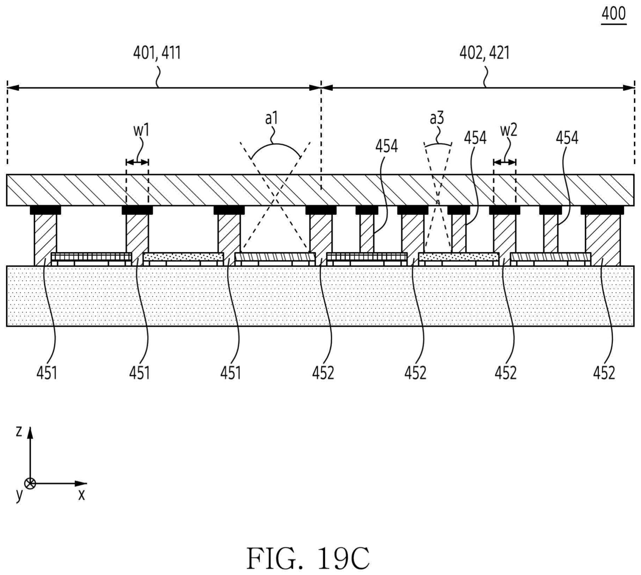

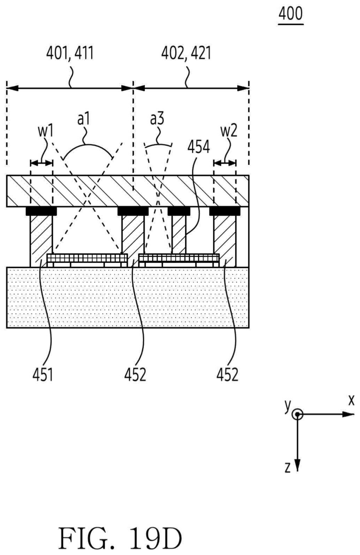

FIG. 19A is a top view of sub-pixels of an exemplary display according to an embodiment, FIG. 19B is a top view of sub-pixels of an exemplary display according to an embodiment, and FIG. 19C is a cross-sectional view illustrating an example of an exemplary display cut along line D-D' of FIG. 19A according to an embodiment. FIG. 19D is a cross-sectional view illustrating an example of a display 400 of FIG. 19B cut along line E-E'.

Since a display 400 of FIGS. 19A, 19B, 19C, and 19D may be a display 400 in which a structure of a plurality of barriers 450 is changed in the display 400 of FIGS. 16A and 16B, a redundant description will be omitted.

Referring to FIGS. 19A, 19B, 19C, and 19D, according to an embodiment, the plurality of barriers 450 may include a plurality of first barriers 451, a plurality of second barriers 452, and a plurality of fourth barriers 454. For example, a first width w1 of the plurality of first barriers 451 may be substantially the same as a second width w2 of the plurality of second barriers 452, but it is not limited thereto.

According to an embodiment, the plurality of fourth barriers 454 may be disposed in a second area 402 among a first area 401 and the second area 402 of the display 400. The plurality of fourth barriers 454 may be disposed outside the first area 401. The plurality of fourth barriers 454 may divide each of a plurality of second sub-pixels 421 into a plurality of micro-pixels 421b and 421c smaller than a size of each of the plurality of second sub-pixels 421, by being disposed in each of the plurality of second sub-pixels 421. A third viewing angle a3 of each of the plurality of micropixels 421b and 421c defined (or formed) by the plurality of fourth barriers 454 disposed in the second area 402 may be smaller than a first viewing angle a1 of each of the plurality of first sub-pixels 411.

As described above, an electronic device according to an embodiment (e.g., the electronic device 101 of FIG. 3) may provide a structure including the plurality of micro-pixels 421b and 421c having the third viewing angle a3 different from the first viewing angle a1 of each of the plurality of first sub-pixels 411, by the plurality of fourth barriers 454 dividing the plurality of second sub-pixels 421 in the second area 402.

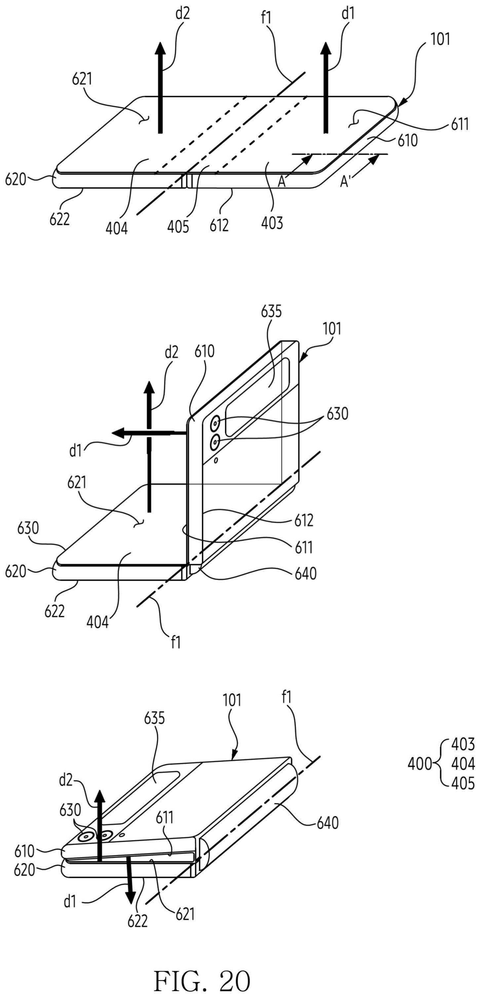

Meanwhile, a description of the display 400 with respect to one of the above-described drawings may be applied to a description of the display 400 with respect to another drawing. For example, a portion of the display 400 according to an embodiment may include all of the structure illustrated in one of FIGS. 4 to 19C, and another portion of the display 400 may include the structure illustrated in another one of FIGS. 4 to 19D. For example, the display 400 according to an embodiment may include both the structure of the display 400 of FIG. 4 and the structure of at least one of the display 400 of FIGS. 5 to 19D. For example, a description of the display 400 including the plurality of structures described above may be described with reference to FIG. 20.

FIG. 20 indicates an exemplary electronic device according to an embodiment.

Referring to FIG. 20, an electronic device 101 may include a first housing 610, a second housing 620, and a display 400 (e.g., the display 210 of FIG. 2), at least one camera 630 (e.g., the camera module 180 of FIG. 1), and/or a hinge structure 640.

The first housing 610 and the second housing 620 may form at least a portion of an outer surface of the electronic device 101 that may be gripped by a user. The at least a portion of the outer surface of the electronic device 101 defined by the first housing 610 and the second housing 620 may be in contact with a part of a body of the user when the electronic device 101 is used by the user. According to an embodiment, the first housing 610 may include a first surface 611 and a second surface 612 facing the first surface 611 and spaced apart from the first surface 611. For example, a direction in which the second surface 612 faces may be opposite to a first direction d1 in which the first surface 611 faces.

According to an embodiment, the second housing 620 may include a third surface 621 and a fourth surface 622 facing the third surface 621 and spaced apart from the third surface 621. The fourth surface 622 may be opposite to the third surface 621. For example, a direction in which the fourth surface 622 faces may be opposite to a second direction d2 in which the third surface 621 faces. According to an embodiment, the second housing 620 may be coupled to the first housing 610 to be rotatable with respect to the first housing 610.

According to an embodiment, the display 400 may be disposed on the first surface 611 of the first housing 610 and the third surface 621 of the second housing 620 across the hinge structure 640. For example, the display 400 may be referred to as a flexible display. According to an embodiment, the display 400 may further include a sub-display 635 disposed on the second surface 622 of the first housing 610. For example, the sub-display 635 may be exposed to the outside of the electronic device 101 through the second surface 422.

According to an embodiment, the at least one camera 630 may be configured to obtain an image based on receiving light from an external subject of the electronic device 101. According to an embodiment, the at least one camera 630 may be disposed inside the first housing 610, and may be at least partially visible through the second surface 612 of the first housing 610.

According to an embodiment, the hinge structure 640 may rotatably connect the first housing 610 and the second housing 620. The hinge structure 640 may be disposed between the first housing 610 and the second housing 620 of the electronic device 101 so that the electronic device 101 may be folded. The hinge structure 640 may change the electronic device 101 into an unfolding state in which the first direction d1 in which the first surface 611 of the first housing 610 faces and the second direction d2 in which the third surface 621 of the second housing 620 faces are substantially the same as each other, or a folding state in which the first surface 611 and the third surface 621 face each other. When the electronic device 101 is in the folding state, the first housing 610 and the second housing 620 may be stacked or overlapped by facing each other. According to an embodiment, when the electronic device 101 is in the folding state, the first direction d1 in which the first surface 611 faces and the second direction d2 in which the third surface 621 faces may be different from each other. For example, when the electronic device 101 is in the folding state, the first direction d1 in which the first surface 611 faces and the second direction d2 in which the third surface 621 faces may be opposite to each other. However, it is not limited thereto. For example, a state of the electronic device 101 may include an intermediate state in which the first direction d1 in which the first surface 611 faces and the second direction d2 in which the third surface 621 faces are inclined with respect to each other. When the first direction d1 in which the first surface 611 faces is inclined with respect to the second direction d2 in which the third surface 621 faces, the first housing 610 may be inclined with respect to the second housing 620. For example, the intermediate state of electronic device 101 may be referred to as a flex mode.

FIG. 20 illustrates that the display 400 is not exposed to the outside of the electronic device 101 in the folding state (e.g., an in-folding state) of the electronic device 101, but it is not limited thereto. For example, the second housing 620 may be rotatable with respect to the first housing 610 so that the second surface 612 and the fourth surface 622 face each other in the folding state of the electronic device 101. For example, the second housing 620 may be rotatable with respect to the first housing 610 so that the display 400 is directly exposed to the outside of the electronic device 101 in the folding state (e.g., an out-folding state).

According to an embodiment, the electronic device 101 may be foldable with respect to a folding axis f1. The display 400 may be foldable with respect to the folding axis f1 by movement of the second housing 620 with respect to the first housing 610.

For example, the folding axis f1 may mean a virtual line extending through the hinge structure 650 in a direction substantially perpendicular to a longitudinal direction of the electronic device 101, but it is not limited thereto. For example, the folding axis f1 may be a virtual line extending in a direction substantially parallel to the longitudinal direction of the electronic device 101. When the folding axis f1 extends in the direction substantially parallel to the longitudinal direction of the electronic device 101, the hinge structure 640 may connect the first housing 610 and the second housing 620 by extending in a direction parallel to the folding axis f1.

According to an embodiment, the display 400 may include a first flat portion 403, a second flat portion 404, and/or a deformation portion 405.

According to an embodiment, the first flat portion 403 may be disposed on the first housing 610. A shape of the first flat portion 403 may be maintained while the state of the electronic device 101 is changed. The shape of the first flat portion 403 may not be changed according to a change in the state of the electronic device 101. The first flat portion 403 may move together with the first housing 610 while the first housing 610 moves with respect to the second housing 620.

According to an embodiment, the second flat portion 404 may be disposed on the second housing 620. A shape of the second flat portion 404 may be maintained while the state of the electronic device 101 is changed. The shape of the second flat portion 404 may not be changed according to a change in the state of the electronic device 101. The second flat portion 404 may move together with the second housing 620 while the second housing 620 moves with respect to the first housing 610. The second flat portion 404 may be spaced apart from the first flat portion 403.

According to an embodiment, the deformation portion 405 may connect the first flat portion 403 and the second flat portion 404. The deformation portion 405 may be disposed between the first flat portion 403 and the second flat portion 404. The deformation portion 405 may be deformed by movement of the second housing 620 with respect to the first housing 610 and/or movement of the first housing 610 with respect to the second housing 620. For example, the deformation portion 405 may have a substantially planar shape in the unfolding state of the electronic device 101. For example, the deformation portion 405 may be folded in the folding state and/or the intermediate state of the electronic device 101.

According to an embodiment, one of the first flat portion 403, the second flat portion 404, and the deformation portion 405 may have a structure different from that of another one of the first flat portion 403, the second flat portion 404, and the deformation portion 405. For example, the first flat portion 403 may include the structure according to FIG. 4, and one of the second flat portion 404 and the deformation portion 405 may include at least one structure of the display 400 of FIGS. 5 to 19C.

According to an embodiment, a second state of a display driving circuit (e.g., the display driving circuit 230 of FIG. 3) may be provided only to a portion of the display 400. For example, in the second state of the display driving circuit 230, a plurality of first sub-pixels (e.g., the plurality of first sub-pixels 411 of FIG. 3) in the first flat portion 403 and a plurality of second sub-pixels (e.g., the plurality of second sub-pixels 421 of FIG. 3) in the first flat portion 403 may be activated, and at least a portion of the plurality of first sub-pixels 411 in the second flat portion 404 may be deactivated. However, it is not limited thereto. For example, the second state of the display driving circuit 230 may be provided to an entire area of the display 400.

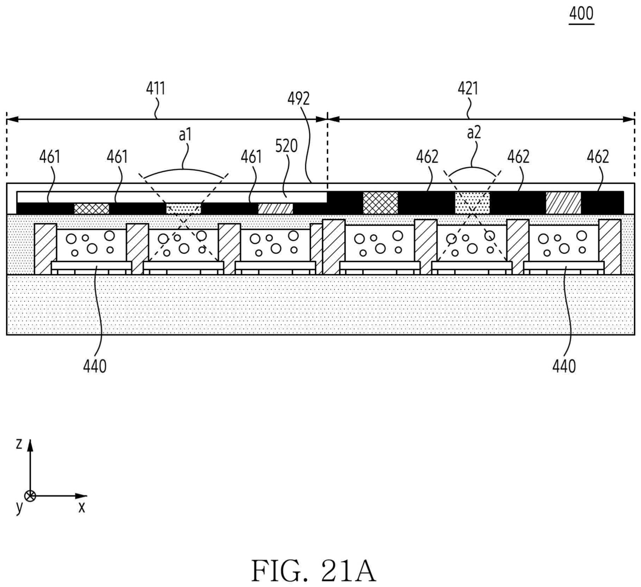

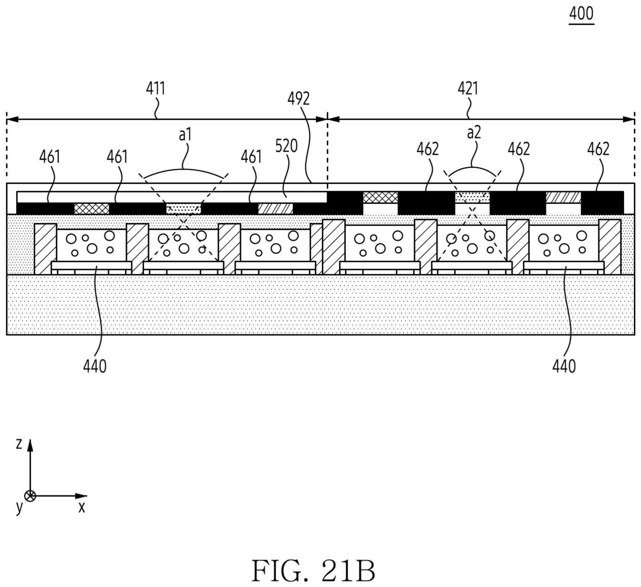

FIG. 21A is a cross-sectional view illustrating an example of cutting an exemplary display according to an embodiment, and FIG. 21B is a cross-sectional view illustrating an example of cutting an exemplary display according to an embodiment.

Since a display 400 of FIG. 21A may be a display 400 in which a structure of a plurality of second blocking members 462 is changed and a compensation layer 520 is added in the display 400 of FIG. 7, a redundant description will be omitted.

Since a display 400 of FIG. 21B may be a display 400 in which a structure of each of a plurality of second blocking members 472 and a plurality of second color filters 482 is changed, and a compensation layer 520 is added in the display 400 of FIG. 7, a redundant description will be omitted.

Referring to FIGS. 21A and 21B, according to an embodiment, a thickness of the plurality of second blocking members 462 may be different from a thickness of a plurality of first blocking members 461. For example, the thickness of each of the plurality of second blocking members 462 may be thicker than the thickness of each of the plurality of first blocking members 461. As the thickness of the plurality of second blocking members 462 is thicker than the thickness of the plurality of first blocking members 461, a second viewing angle a2 of a plurality of second sub-pixels 421 defined by the plurality of second blocking members 462 may be narrower than a first viewing angle a1 of a plurality of first sub-pixels 411 defined by the plurality of first blocking members 461.

According to an embodiment, the compensation layer 520 may compensate for a step between the thickness of the plurality of first blocking members 461 and the thickness of the plurality of second blocking members 462. For example, a thickness of the compensation layer 520 may be substantially the same as a difference between the thickness of the plurality of second blocking members 462 and the thickness of the plurality of first blocking members 461. The compensation layer 520 may be disposed on the plurality of first blocking members 461 and a plurality of first color filters 481. For example, the compensation layer 520 may be disposed (or interposed) between the plurality of first blocking members 461 and a second passivation layer 492, and between the plurality of first color filters 481 and the second passivation layer 492.

Referring to FIG. 21A, according to an embodiment, a thickness of the plurality of second color filters 482 may be substantially the same as the thickness of the plurality of second blocking members 462. The thickness of the plurality of second color filters 482 disposed between the plurality of second blocking members 462 may be thicker than a thickness of the plurality of first color filters 481 disposed between the plurality of first blocking members 461.

Referring to FIG. 21B, according to an embodiment, the thickness of the plurality of second color filters 482 may be thinner than the thickness of the plurality of second blocking members 462. The thickness of the plurality of second color filters 482 disposed between the plurality of second blocking members 462 may be substantially the same as the thickness of the plurality of first color filters 481 disposed between the plurality of first blocking members 461. For example, a distance between each of a plurality of LEDs 440 and each of the plurality of second color filters 482 in the plurality of second sub-pixels 421 may be greater than a distance between each of the plurality of LEDs 440 and each of the plurality of first color filters 481 in the plurality of first sub-pixels 411, but it is not limited thereto. For example, the distance between each of the plurality of LEDs 440 and each of the plurality of second color filters 482 in the plurality of second sub-pixels 421 may be substantially the same as the distance between each of the plurality of LEDs 440 and each of the plurality of first color filters 481 in the plurality of first sub-pixels 411.

As described above, the display 400 according to an embodiment may provide a structure in which the second viewing angle a2 of each of the plurality of second sub-pixels 421 is narrower than the first viewing angle a1 of each of the plurality of first sub-pixels 411, since the thickness of the plurality of second blocking members 462 is thicker than the thickness of the plurality of first blocking members 461.

A screen displayed by a display of an electronic device may be visible not only when viewing the screen from the front but also when viewing the screen at an angle different from the angle of viewing the front of the screen. When the screen is visible from the different angle, another person in addition to a user of the electronic device may view the screen of the electronic device. The electronic device may need a structure for protecting privacy of the user of the electronic device.

The technical problems to be achieved in this document are not limited to those described above, and other technical problems not mentioned herein will be clearly understood by those having ordinary knowledge in the art to which the present disclosure belongs, from the following description.

The effects that can be obtained from the present disclosure are not limited to those described above, and any other effects not mentioned herein will be clearly understood by those having ordinary knowledge in the art to which the present disclosure belongs, from the following description.

A display (e.g., the display 400 of FIG. 3) is provided. According to an embodiment, the display may comprise a substrate (e.g., the substrate 430 of FIG. 4). According to an embodiment, the display may comprise a plurality of LEDs (e.g., the plurality of LEDs 440 of FIG. 4) spaced apart from each other and each of the plurality of LEDs including a first surface (e.g., the first surface 441 of FIG. 4) facing the substrate, a second surface e.g., the second surface 442 of FIG. 4) through which light is emitted and opposite to the first surface, and a side surface (e.g., the side surface 443 of FIG. 4) connecting the first surface and the second surface. According to an embodiment, the display may comprise a plurality of barriers (e.g., the plurality of barriers 450 of FIG. 4) covering the side surface of each of the plurality of LEDs and including a plurality of first barriers (e.g., the plurality of first barriers 451 of FIG. 4) having a first volume and spaced apart from each other, and a plurality of second barriers (e.g., the plurality of second barriers 452 of FIG. 4) having a second volume different from the first volume and spaced apart from each other. According to an embodiment, the display may comprise a plurality of first sub-pixels (e.g., the plurality of first sub-pixels 411 of FIG. 4) defined by the plurality of first barriers and each of the plurality of first sub-pixels having a first viewing angle. According to an embodiment, the display may comprise a plurality of second sub-pixels (e.g., the plurality of first sub-pixels 421 of FIG. 4) defined by the plurality of second barriers and each of the plurality of second sub-pixels having a second viewing angle narrower than the first viewing angle.

The display according to an embodiment may provide a structure in which the second viewing angle of the plurality of second sub-pixels is narrower than the first viewing angle of the plurality of first sub-pixels, by the plurality of second barriers having a different volume from the plurality of first barriers.

According to an embodiment, the plurality of barriers may include at least one third barrier (e.g., the at least one third barrier 453 of FIG. 3) disposed between the plurality of first sub-pixels and the plurality of second sub-pixels. According to an embodiment, the at least one third sub-pixel may have a third volume between the first volume and the second volume.

The display according to an embodiment may provide a structure in which each of the plurality of first sub-pixels and the plurality of second sub-pixels has a uniform viewing angle by the at least one third barrier having a volume different from the plurality of first barriers and the plurality of second barriers.

According to an embodiment, a width of each of the plurality of second barriers may be larger than a width of each of the plurality of first barriers.

The display according to an embodiment may provide the structure in which the second viewing angle of the plurality of second sub-pixels is narrower than the first viewing angle of the plurality of first sub-pixels, by the plurality of second barriers having a width larger than that of the plurality of first barriers.

According to an embodiment, a thickness of each of the plurality of second barriers may be larger than a thickness of each of the plurality of first barriers.

The display according to an embodiment may provide a structure in which the second viewing angle of the plurality of second sub-pixels is narrower than the first viewing angle of the plurality of first sub-pixels, by the plurality of second barriers having a thickness lager than that of the plurality of first barriers.

According to an embodiment, the display may include a light conversion member (e.g., the plurality of light conversion members 470 of FIG. 3) covered by at least a portion of the plurality of barriers by disposing on the second surface of at least a portion of the plurality of LEDs.

The display according to an embodiment may be configured to provide various visual content by the light conversion member that converts light from the plurality of LEDs.

According to an embodiment, each of the plurality of barriers may be in contact with a portion of the second surface of each of the plurality of LEDs.

The display according to an embodiment may provide the structure in which the second viewing angle of the plurality of second sub-pixels is narrower than the first viewing angle of the plurality of first sub-pixels, by the plurality of barriers being in contact with the portion of the second surface of each of the plurality of LEDs.

According to an embodiment, the display may further include a plurality of blocking members (e.g., the plurality of blocking members 460 of FIG. 3) spaced apart from each other and each of the plurality of blocking members being disposed on each of the plurality of barriers. According to an embodiment, the plurality of blocking members may include a plurality of first blocking members (e.g., the plurality of first blocking members 461 of FIG. 3) disposed on each of the plurality of first barriers and defining the plurality of first sub-pixels with the plurality of first barriers. According to an embodiment, the plurality of blocking members may include a plurality of second blocking members (e.g., the plurality of second blocking members 462 of FIG. 3) disposed on each of the plurality of second barriers and defining the plurality of second sub-pixels with the plurality of second barriers.

The display according to an embodiment may provide the structure in which the second viewing angle of the plurality of second sub-pixels are narrower than the first viewing angle of the plurality of first sub-pixels, by the plurality of first blocking members disposed on the plurality of first sub-pixels and the plurality of second blocking members disposed on the plurality of second sub-pixels.

According to an embodiment, a distance between the plurality of second blocking members and one LED among the plurality of LEDs in the plurality of second sub-pixels may be bigger than a distance between the plurality of first blocking members and another LED among the plurality of LEDs.

According to an embodiment, the display may include a covering layer (e.g., the covering layer 510 of FIG. 11) disposed on the plurality of blocking members. According to an embodiment, the display may include a compensation player (e.g., the compensation layer 520 of FIG. 12) interposed between the covering layer and the plurality of first blocking members.

According to an embodiment, an area of a surface of each of the plurality of second barriers facing a direction in which the second surface faces may be larger than an area of a surface of each of the plurality of first barriers facing the direction in which the second surface faces.

The display according to an embodiment may provide the structure in which the second viewing angle of the plurality of second sub-pixels is narrower than the first viewing angle of the plurality of first sub-pixels, by the plurality of second barriers having a different shape from the plurality of first barriers.

According to an embodiment, a width of each of the plurality of first barriers may be reduced as it goes farther from the substrate. According to an embodiment, a width of each of the plurality of second barriers may be increased as it goes farther from the substrate.

The display according to an embodiment may provide the structure in which the second viewing angle of the plurality of second sub-pixels is narrower than the first viewing angle of the plurality of first sub-pixels, by the plurality of second barriers having a different shape from the plurality of first partition walls.

According to an embodiment, the plurality of barriers may further include at least one fourth barrier (e.g., the at least one fourth barrier 454 of FIG. 10B) disposed between the plurality of second barriers.

The display according to an embodiment may provide a structure having micro-pixels having a viewing angle narrower than the first viewing angle of the plurality of first sub-pixels by the at least one fourth barrier.

According to an embodiment, each of the plurality of barriers may include a material for blocking the light.

According to an embodiment, the display may further include a passivation layer e.g., the first passivation layer 491 of FIG. 4) disposed on the substrate and covering the plurality of barriers.

According to an embodiment, when the display is viewed along a direction in which the first surface faces, a size of each of the plurality of second sub-pixels may be smaller than a size of each of the plurality of first sub-pixels.

The display according to an embodiment may provide the structure in which the second viewing angle of the plurality of second sub-pixels is narrower than the first viewing angle of the plurality of first sub-pixels, by the plurality of second sub-pixels having a size smaller than that of the first sub-pixels.

An electronic device (e.g., the electronic device 101 of FIG. 3) is provided. According to an embodiment, the electronic device may comprise a display (e.g., the display 400 of FIG. 3). According to an embodiment, the electronic device may comprise a display driving circuit (e.g., the display driving circuit 230 of FIG. 3) configured to control the display. According to an embodiment, the display may include a plurality of LEDs (e.g., the plurality of LEDs 440 of FIG. 4) spaced apart from each other and each of the plurality of LEDs including a first surface (e.g., the first surface 441 of FIG. 4) facing the substrate, a second surface (e.g., the second surface 442 of FIG. 4) through which light is emitted and opposite to the first surface, and a side surface (e.g., the side surface 443 of FIG. 4) connecting the first surface and the second surface. According to an embodiment, the display may include a plurality of barriers (e.g., the plurality of barriers 450 of FIG. 4) covering the side surface of each of the plurality of LEDs and including a plurality of first barriers (e.g., the plurality of first barriers 451 of FIG. 4) having a first volume and spaced apart from each other, and a plurality of second barriers (e.g., the plurality of second barriers 452 of FIG. 4) having a second volume different from the first volume and spaced apart from each other. According to an embodiment, the display may include a plurality of first sub-pixels (e.g., the plurality of first sub-pixels 411 of FIG. 4) defined by the plurality of first barriers and each of the plurality of first sub-pixels having a first viewing angle a1. According to an embodiment, the display may include a plurality of second sub-pixels (e.g., the plurality of second sub-pixels 421 of FIG. 4) defined by the plurality of second barriers and each of the plurality of second sub-pixels having a second viewing angle a2 narrower than the first viewing angle a1. According to an embodiment, the display driving circuit may be configured to, in a first state, display, a screen on the display, based on activating the plurality of first sub-pixels and the plurality of second sub-pixels. According to an embodiment, the display driving circuit may be configured to, in a second state, display the screen on the display, based on activating a portion of the plurality of first sub-pixels and the plurality of second sub-pixels, or based on activating the plurality of second sub-pixels.

The display according to an embodiment may provide a structure in which the second viewing angle of the plurality of second sub-pixels is narrower than the first viewing angle of the plurality of first sub-pixels, by the plurality of second barriers having a different volume from the plurality of first barriers.

According to an embodiment, the plurality of barriers may include at least one third barrier (e.g., the at least one third barrier 453 of FIG. 3) disposed between the plurality of first sub-pixels and the plurality of second sub-pixels. According to an embodiment, the at least one third sub-pixel may have a third volume between the first volume and the second volume.

According to an embodiment, a width of each of the plurality of second barriers may be larger than a width of each of the plurality of first barriers.

The display according to an embodiment may provide the structure in which the second viewing angle of the plurality of second sub-pixels is narrower than the first viewing angle of the plurality of first sub-pixels, by the plurality of second barriers having a width larger than that of the plurality of first barriers.

According to an embodiment, a thickness of each of the plurality of second barriers may be larger than a thickness of each of the plurality of first barriers.

The display according to an embodiment may provide the structure in which the second viewing angle of the plurality of second sub-pixels is narrower than the first viewing angle of the plurality of first sub-pixels, by the plurality of second barriers having a thickness larger than that of the plurality of first barriers.

According to an embodiment, when the display is viewed from above, a size of each of the plurality of second sub-pixels may be smaller than a size of each of the plurality of first sub-pixels.

The display according to an embodiment may provide the structure in which the second viewing angle of the plurality of second sub-pixels is narrower than the first viewing angle of the plurality of first sub-pixels, by the plurality of second sub-pixels having a size smaller than the size of the first sub-pixels.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. A display (400) comprising:
a substrate (430);
a plurality of LEDs (440) spaced apart from each other and each of the plurality of LEDs including a first surface (441) facing the substrate (430), a second surface (442) through which light is emitted and opposite to the first surface (441), and a side surface (443) connecting the first surface (441) and the second surface (442);
a plurality of barriers (450) covering the side surface (443) of each of the plurality of LEDs (440) and including a plurality of first barriers (451) having a first volume and spaced apart from each other, and a plurality of second barriers (452) having a second volume different from the first volume and spaced apart from each other;
a plurality of first sub-pixels (411) defined by the plurality of first barriers (451) and each of the plurality of first sub-pixels having a first viewing angle (a1); and
a plurality of second sub-pixels (421) defined by the plurality of second barriers (452) and each of the plurality of second sub-pixels having a second viewing angle (a2) narrower than the first viewing angle (a1).

2. The display (400) of claim 1,
wherein the plurality of barriers (450) includes at least one third barrier (453) disposed between the plurality of first sub-pixels (411) and the plurality of second sub-pixels (421), and
wherein the at least one third barrier (453) has a third volume between the first volume and the second volume.

3. The display (400) according to any one of claims 1 to 2,
wherein a width of each of the plurality of second barriers (452) is larger than a width of each of the plurality of first barriers (451).

4. The display (400) according to any one of claims 1 to 2,
wherein a thickness of each of the plurality of second barriers (452) is larger than a thickness of each of the plurality of first barriers (451).

5. The display (400) according to any one of claims 1 to 4,
wherein the display further includes a light conversion member (470) covered by at least a portion of the plurality of barriers (450) by disposing on the second surface (442) of at least a portion of the plurality of LEDs (440).

6. The display (400) according to any one of claims 1 to 5,
wherein each of the plurality of barriers (450) is in contact with a portion of the second surface (442) of each of the plurality of LEDs (440).

7. The display (400) according to any one of claims 1 to 6,
wherein the display (400) further includes a plurality of blocking members (460) spaced apart from each other and each of the plurality of blocking members being disposed on each of the plurality of barriers (450), and
wherein the plurality of blocking members (460) includes:
a plurality of first blocking members (461) disposed on each of the plurality of first barriers (451) and defining the plurality of first sub-pixels (411) with the plurality of first barriers (451); and
a plurality of second blocking members (462) disposed on each of the plurality of second barriers (452) and defining the plurality of second sub-pixels (421) with the plurality of second barriers (452).

8. The display (400) of claim 7,
wherein a distance between the plurality of second blocking members (462) and one LED among the plurality of LEDs (440) in the plurality of second sub-pixels (421) is bigger than a distance between the plurality of first blocking members (461) and another LED among the plurality of LEDs (440) in the plurality of first sub-pixels (411).

9. The display (400) of claim 7,
wherein the display further includes:
a covering layer (510) disposed on the plurality of blocking members (460); and
a compensation player (520) interposed between the covering layer (510) and the plurality of first blocking members (461).

10. The display (400) according to any one of claims 1 to 9,
wherein an area of a surface of each of the plurality of second barriers (452) facing a direction in which the second surface (442) faces is larger than an area of a surface of each of the plurality of first barriers (451) facing the direction in which the second surface (442) faces.

11. The display (400) of claim 10,
wherein a width of each of the plurality of first barriers (451) is reduced as it goes farther from the substrate (430), and
wherein a width of each of the plurality of second barriers (452) is increased as it goes farther from the substrate (430).

12. The display (400) according to any one of claims 1 to 11,
wherein the plurality of barriers (450) further includes at least one fourth barrier disposed between the plurality of second barriers (452).

13. The display (400) of claim 1,
wherein each of the plurality of barriers (450) includes a material for blocking the light.

14. The display (400) according to any one of claims 1 to 13,
wherein the display further includes a passivation layer (490) disposed on the substrate (430) and covering the plurality of barriers (450).

15. The display (400) according to any one of claims 1 to 14,
wherein when the display (400) is viewed along a direction in which the first surface (441) faces, a size of each of the plurality of second sub-pixels (421) is smaller than a size of each of the plurality of first sub-pixels (411).
